# EUROPEAN PATENT APPLICATION

(11) **EP 4 750 262 A1**
(43) Date of publication of application: **27.05.2026**
(21) Application number: 25216222.7
(22) Date of filing: 17.11.2025
(51) Int. Cl.: H10D 86/40, H10D 86/60, H10K 59/123, H10K 59/131, H10K 59/121, H10K 71/00

(54) **DISPLAY DEVICE**

(30) Priority: 26.11.2024 KR 20240170284
(71) Applicant: LG Display Co., Ltd., Seoul, 07336 (KR)
(72) Inventor: PARK, JaeHee, 10845 Paju-si (KR); KO, Taehee, 10845 Paju-si (KR); KIM, Chaiwon, 10845 Paju-si (KR)
(74) Representative: Ter Meer Steinmeister & Partner

(57) **Abstract**

A display device includes a substrate having a plurality of sub-pixels. A driving thin film transistor is disposed in each sub-pixel and includes a source electrode and a drain electrode. A first electrode is disposed in each sub-pixel and is electrically connected to the source electrode or the drain electrode. The first electrode comprises a first sub-electrode and a second sub-electrode spaced apart from each other. The first sub-electrode is electrically connected to the source electrode or the drain electrode through a first connection electrode. The second sub-electrode is electrically connected to the source electrode or the drain electrode through a second connection electrode. The arrangement allows selective electrical isolation of one of the sub-electrodes in response to a defect, while enabling continued operation of the other sub-electrode.

## Description

This application claims the benefit of the Republic of Korea Patent Application No. 10-2024-0170284 filed on November 26, 2024.

### BACKGROUND

### Technical Field

The present disclosure relates to a display device.

### Description of the Related Art

A display device includes a plurality of signal lines and a plurality of thin film transistors connected to the plurality of signal lines. The signal lines may include, for example, gate lines for transmitting gate signals, data lines for transmitting image data, and power lines for supplying driving power. The thin film transistors operate in response to the signals supplied through the signal lines to control the flow of current to corresponding light emitting elements. In high resolution display devices, these lines are arranged in multiple layers to achieve a compact layout that accommodates the large number of connections required for fine pixel control.

In such multilayer configurations, certain signal lines are positioned above or below others with an insulating layer disposed between them. This arrangement allows the lines to cross without direct electrical contact, enabling a denser circuit layout while maintaining electrical isolation. The insulating layer may be formed of an inorganic material such as silicon nitride or silicon oxide, or an organic insulating material, depending on the required electrical and mechanical characteristics.

### BRIEF SUMMARY

However, during the manufacturing process of the display device, unwanted particles can be generated at various stages, such as during thin film deposition, photolithography, or etching. These particles may become embedded within the insulating layer or trapped at the interface between conductive and insulating layers. When such particles are present between overlapping signal lines, they can form unintended conductive paths or reduce the dielectric strength of the insulating layer.

As a result, a short defect may occur between signal lines that are intended to remain electrically isolated. For example, particles trapped between a gate line and an overlapping data line can cause these lines to be electrically connected, leading to malfunction of the associated thin film transistors and deterioration of display quality. In severe cases, the short defect may disable an entire pixel or group of pixels, thereby reducing manufacturing yield and reliability.

Accordingly, it is an object of the present invention to provide a display device capable of preventing a short defect problem between a plurality of signal lines due to particles occurring during a manufacturing process.

It is another object of the present invention to at least reduce parasitic capacitance in high density layouts where a transistor of one sub-pixel overlaps the anode of an adjacent sub-pixel.

At least one of the above objects and objects that the skilled person may derive from the specification is solved by the features of the independent claim 1. Further embodiments are described by the dependent claims, the specification and the drawings.

According to an aspect of the invention, a pixel architecture is described in which each sub-pixel anode is divided into two sub-electrodes, each supplied by its own connection from the driving thin-film transistor through separate electrodes and contact holes. The sub-pixel anode may be referred to as split anode. These connections are arranged so that portions of the conductive paths pass between the two sub-electrodes in an area that does not contain the source electrode of the transistor, allowing a repair laser to cut only the defective path without damaging the transistor. Variations include a branched arrangement where one connection is formed as part of the other, and a segmented source node with vias positioned to ensure the cut zone is over insulating regions. These structural arrangements are presented as a means to isolate a shorted sub-electrode caused by particle contamination during manufacture while maintaining operation of the unaffected sub-electrode.

According to an aspect of the invention, a shielding layer is provided. The shielding layer may be a dedicated conductor or the extended connection electrode itself, positioned between the overlapping transistor and the adjacent anode. Additional dielectric layers can be used to enhance the shielding effect. The layout also places signal lines directly adjacent to one another without intervening wiring to reduce the overall circuit footprint, increasing the transmissive region and enabling a larger aperture ratio or higher resolution in a top emission configuration.

The combination of the split anode with separate conductive feeds, the nonoverlapping geometry that enables selective repair, the optional branched connection arrangement, and the integrated shielding may increase a manufacturing yield due to avoidance of shorts between stacked lines caused by particles, and reduced variations in display characteristics resulting from parasitic coupling in densely arranged layouts. Further features may include the defined segmentation of electrodes, prescribed routing of conductive paths, and shielding structures arranged to support continued pixel operation and stable image characteristics within the manufacturing and layout conditions described.

In accordance with an aspect of the present invention, the above and other technical effects can be accomplished by the provision of a display device comprising a substrate including a plurality of sub-pixels, a driving thin film transistor disposed in each of the plurality of sub-pixels on the substrate and including a source electrode and a drain electrode, and a first electrode disposed in each of the plurality of sub-pixels on the substrate and connected to the source electrode or the drain electrode, wherein the first electrode comprises a first sub-electrode and a second sub-electrode spaced apart from each other, and wherein the first sub-electrode is electrically connected to the source electrode or the drain electrode through a first connection electrode, and the second sub-electrode is electrically connected to the source electrode or the drain electrode through a second connection electrode.

In accordance with an aspect of the present invention, the above and other technical effects can be accomplished by the provision of a display device comprising a substrate, a first insulating layer on the substrate, a source electrode or a drain electrode of a driving thin film transistor on the first insulating layer, a second insulating layer on the source electrode or the drain electrode, a first connection electrode and a second connection electrode disposed on the second insulating layer and electrically connected to the source electrode or the drain electrode through a first contact hole disposed in the second insulating layer, a third insulating layer on the first connection electrode and the second connection electrode, and a first electrode disposed on the third insulating layer and connected to the first connection electrode and the second connection electrode through a second contact hole disposed in the third insulating layer, wherein the first connection electrode is connected to the source electrode or the drain electrode through one of the first contact hole, and the second connection electrode spaced apart from the first connection electrode and connected to the source electrode or the drain electrode through another of the first contact hole, wherein the first electrode includes a first sub-electrode connected to the first connection electrode through one second contact hole, and a second sub-electrode spaced apart from the first sub-electrode and connected to the second connection electrode through another second contact hole.

In accordance with an aspect of the present disclosure, the above and other technical effects can be accomplished by the provision of a display device comprising a substrate, a first insulating layer on the substrate, a source electrode or a drain electrode of a driving thin film transistor on the first insulating layer, a second insulating layer on the source electrode or the drain electrode, a connection electrode disposed on the second insulating layer and electrically connected to the source electrode or the drain electrode through a first contact hole disposed in the second insulating layer, a third insulating layer on the connection electrode, and a first electrode disposed on the third insulating layer and connected to the connection electrode through a second contact hole disposed in the third insulating layer, wherein the connection electrode includes a first connection electrode connected to the source electrode or the drain electrode through the first contact hole, and a second connection electrode formed as one body with the first connection electrode and extended in a direction different from the first connection electrode, and wherein the first electrode includes a first sub-electrode connected to the first connection electrode through one of the second contact hole, and a second sub-electrode spaced apart from the first sub-electrode and connected to the second connection electrode through another of the second contact hole.

The display device according to at least one of the aspects may include one or more of the following features:

The source electrode or the drain electrode may overlap the first sub-electrode and/or the second sub-electrode.

The source electrode or the drain electrode may include a first part overlapping the first sub-electrode. The source electrode or the drain electrode may include a second part overlapping the second sub-electrode. The source electrode or the drain electrode may include a third part overlapping a region between the first sub-electrode and the second sub-electrode. The region may be defined by the spacing between the first sub-electrode and the second sub-electrode. The third part may connect the first part with or to the second part.

A width of the third part in the first direction may be smaller than a width of the first part in the first direction. The width of the third part in the first direction may be smaller than a width of the second part in the first direction.

The first connection electrode and the second connection electrode may overlap the first part and the second part. The first connection electrode may overlap the first part and the second connection electrode may overlap the second part. The first connection electrode and the second connection electrode may overlap each one of the first part and the second part. In particular, none of the first connection electrode and the second connection electrode does overlap the third part.

The first connection electrode may extend from an area overlapping the first sub-electrode to an area overlapping the second sub-electrode. The second connection electrode may extend from an area overlapping the first sub-electrode to an area overlapping the second sub-electrode.

A first end of the first connection electrode may be connected to the source electrode or the drain electrode through a first contact hole. A second end of the first connection electrode may be connected to the first sub-electrode through a second contact hole. The first contact hole may be positioned to overlap, in plan view, the second sub-electrode. The second contact hole may be positioned to overlap, in plan view, the first sub-electrode.

A first end of the second connection electrode may be connected to the source electrode or the drain electrode through a first contact hole. A second end of the second connection electrode may be connected to the second sub-electrode through a second contact hole. The first contact hole may be positioned to overlap, in plan view, the first sub-electrode. The second contact hole may be positioned to overlap, in plan view, the second sub-electrode.

The first connection electrode may include a first part overlapping the first sub-electrode. The first connection electrode may include a second part overlapping the second sub-electrode. The first connection electrode may include a third part connecting the first part with the second part. Optionally, the third part does not overlap the first sub-electrode. Optionally, the third part does not overlap the second sub-electrode. In particular, the third part neither overlaps the first sub-electrode nor the second sub-electrode.

The first part of the first connection electrode may overlap the first part of the source electrode or the drain electrode. The second part of the first connection electrode may overlap the second part of the source electrode or the drain electrode. Optionally, the third part of the first connection electrode does not overlap the third part of the source electrode or the drain electrode. In particular, the third part of the first connection electrode neither overlaps the third part of the source electrode nor the drain electrode.

The third part of the first connection electrode may be disconnected. The third part of the first connection electrode may be disconnected from the third part of the source electrode and/or the drain electrode.

The source electrode or the drain electrode may overlap the first sub-electrode. Optionally, the source electrode or the drain electrode does not overlap the second sub-electrode. Of the first electrode, the source electrode or the drain electrode may only overlap the first sub-electrode.

A first end of the first connection electrode may be connected to the source electrode or the drain electrode through a first contact hole. A second end of the first connection electrode may be connected to the first sub-electrode through a second contact hole.

The first connection electrode may extend from the first sub-electrode to the second sub-electrode via a first route. The first connection electrode may extend from the second sub-electrode to the first sub-electrode via a second route different from the first route.

The first connection electrode may include two first parts overlapping the first sub-electrode. The two first parts may be spaced apart from each other. The first connection electrode may include a second part overlapping the second sub-electrode. The first connection electrode may include two third parts disposed between the first part and the second part. The two third parts may be disposed in a spaced area between the first sub-electrode and the second sub-electrode. The spaced area may be a gap.

The second connection electrode may branch from the first connection electrode.

A first end of the second connection electrode may overlap the first sub-electrode. A second end of the second connection electrode may overlap the second sub-electrode.

A region between the first sub-electrode and the second sub-electrode may include a gap between the first sub-electrode and the second sub-electrode. The region may be defined by the spacing between the first sub-electrode and the second sub-electrode. The region or the gap may overlap a part of the first connection electrode and a part of the second connection electrode in plan view. Optionally, the region or the gap does not overlap the source electrode or the drain electrode.

It is to be understood that both the foregoing general description and the following detailed description are exemplary and explanatory and are intended to provide further explanation of the inventive concepts as claimed

### BRIEF DESCRIPTION OF THE SEVERAL VIEWS OF THE DRAWINGS

The accompanying drawings, which are included to provide a further understanding of the disclosure and are incorporated in and constitute a part of this application, illustrate embodiments of the disclosure and together with the description explain the principle of the disclosure. In the drawings:
FIG. 1 is a circuit diagram of an electroluminescent display device according to an embodiment of the present disclosure.
FIG. 2 is a plan view of an electroluminescent display device according to an embodiment of the present disclosure.
FIG. 3 is a cross-sectional view of an electroluminescent display device according to an embodiment of the present disclosure, which corresponds to a cross-section taken along line A-A of FIG. 2.
FIG. 4 is a plan view of an electroluminescent display device according to an embodiment of the present disclosure, which illustrates an electrical connection between a second source electrode of a driving thin film transistor and a first electrode functioning as an anode of one sub-pixel.
FIG. 5 is a cross-sectional view of an electroluminescent display device according to an embodiment of the present disclosure, which corresponds to a cross-section taken along line B-B of FIG. 4.
FIG. 6 is a plan view of an electroluminescent display device according to another embodiment of the present disclosure.
FIG. 7 is a cross-sectional view of an electroluminescent display device according to another embodiment of the present disclosure, which corresponds to a cross-section taken along line A-A of FIG. 6.
FIG. 8 is a cross-sectional view of an electroluminescent display device according to another embodiment of the present disclosure, which corresponds to a cross section taken along line C-C of FIG. 6.
FIG. 9 is a cross-sectional view of an electroluminescent display device according to another embodiment of the present disclosure, which corresponds to a cross section taken along line C-C of FIG.6.
FIG. 10 is a plan view of an electroluminescent display device according to another embodiment of the present disclosure, which illustrates an electrical connection between a second source electrode of a driving thin film transistor and a first electrode functioning as an anode of one sub-pixel.
FIG. 11 is a cross-sectional view of an electroluminescent display device according to another embodiment of the present disclosure, which corresponds to a cross-section taken along line B-B of FIG. 10.
FIG. 12 is a plan view of an electroluminescent display device according to another embodiment of the present disclosure.
FIG. 13 is a plan view of an electroluminescent display device according to another embodiment of the present disclosure, which illustrates an electrical connection between a second source electrode of a driving thin film transistor and a first electrode functioning as an anode of one sub-pixel.

Throughout the drawings and the detailed description, unless otherwise described, the same drawing reference numerals should be understood to refer to the same elements, features, and structures.

### DETAILED DESCRIPTION

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have' and 'include' described in the present disclosure are used, another portion may be added unless 'only~' is used. The terms of a singular form may include plural forms unless referred to the contrary.

In interpreting the components, it is interpreted as including the error range even if there is no separate explicit description of the error range.

In describing a position relationship, for example, when the position relationship is described as 'upon~', 'above~', 'below~' and 'next to~', one or more portions may be disposed between two other portions unless 'just' or 'direct' is used. The terms, such as "below," "lower," "above," "upper" and the like, may be used herein to describe a relationship between element (s) as illustrated in the drawings. It will be understood that the terms are spatially relative and based on the orientation depicted in the drawings.

A description of a time relationship may include a case in which the temporal precedence relationship is described as "after", "following", or "before", etc., and is not continuous unless "right away" or "directly", is used.

Although the first, second, and the like are used to describe various components, these components are not limited by these terms. These terms are used only to distinguish one component from another. Therefore, a first component mentioned below may be a second component within a technical idea of a present disclosure.

It will be understood that, although the terms "first," "second," "A," "B," "(a)," and "(b)", etc., may be used herein to describe various elements, these elements should not be limited by these terms. These terms are only used to distinguish one element from another. For example, a first element could be termed a second element, and, similarly, a second element could be termed a first element, without departing from the scope of the present disclosure.

If a component is stated to be "connected," "coupled," "connected," or "attached" to another component, that component may be connected, coupled, connected, or attached directly to that other component, but it should be understood that other components may be interposed between each component that may be connected, coupled, connected, or attached indirectly, without any specific description.

It should be understood that if a component or layer is stated to be "in contact" or "overlapping" with another component or layer, the component or layer may be in direct contact or overlapping with another component or layer, but other components may be interposed between each component that may be indirectly in contact or overlapping without particular explicit description.

To further elaborate, as used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

"First direction", "second direction", "third direction", "X-axis direction", "Y-axis direction", and "Z-axis direction" should not be interpreted only as a geometric relationship perpendicular to each other, but may mean that the configuration of the present disclosure has a wider direction within a range in which the configuration of the present disclosure may functionally act.

Features of each of the various embodiments of the present specification may be partially or entirely coupled or combined with each other, technically various interworking and driving are possible, and each of the embodiments may be independently implemented with respect to each other or may be implemented together in a related relationship.

Hereinafter, one embodiment of the present disclosure will be described in detail with reference to the accompanying drawings.

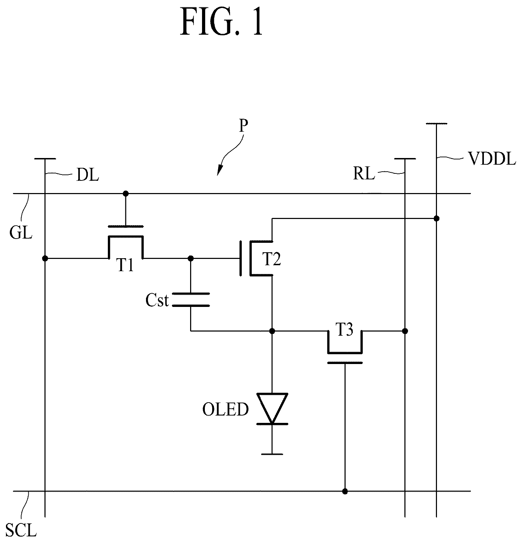

FIG. 1 is a circuit diagram of an electroluminescent display device according to an embodiment of the present disclosure.

As shown in FIG. 1, an electroluminescent display device according to an embodiment of the present disclosure includes a gate line GL, a sensing control line SCL, a high power line VDDL, a data line DL, a reference line RL, a switching thin film transistor T1, a driving thin film transistor T2, a sensing thin film transistor T3, a capacitor Cst, and an organic light emitting diode OLED.

The gate line GL supplies a gate signal to a gate terminal of the switching thin film transistor T1.

The sensing control line SCL supplies a sensing control signal to a gate terminal of the sensing thin film transistor T3. The sensing control line SCL may be omitted, and in this case, the gate terminal of the sensing thin film transistor T3 may be connected to the gate line GL to receive a sensing control signal from the gate line GL.

The high power line VDDL supplies high power to a drain terminal of the driving thin film transistor T2.

The data line DL supplies a data signal to a source terminal of the switching thin film transistor T1.

The reference line RL is connected to a drain terminal of the sensing thin film transistor T3.

The switching thin film transistor T1 is switched according to the gate signal supplied to the gate line GL to supply a data voltage supplied from the data line DL to the driving thin film transistor T2.

The driving thin film transistor T2 is switched according to the data voltage supplied from the switching thin film transistor T1 to generate a data current from the high power source supplied from the high power line VDDL and supplies the data current to the organic light emitting diode OLED.

The sensing thin film transistor T3 senses a threshold voltage deviation of the driving thin film transistor T2, which causes image quality to deteriorate. Such sensing of the threshold voltage deviation may be performed in a sensing mode. The sensing thin film transistor T3 supplies a voltage of the driving thin film transistor T2 to the reference line RL in response to the sensing control signal supplied from the sensing control line SCL.

The capacitor Cst maintains the data voltage supplied to the driving thin film transistor T2 for one frame, and is connected to a gate terminal and a source terminal of the driving thin film transistor T2, respectively.

The organic light emitting diode OLED emits predetermined light according to the data current supplied from the driving thin film transistor T2. The organic light emitting diode OLED includes an anode and a cathode, and a light emitting layer disposed between the anode and the cathode. The anode of the organic light emitting diode OLED is connected to the source terminal of the driving thin film transistor T2, and the cathode of the organic light emitting diode OLED is connected to a low power line. Although not shown, the low power line for supplying low power to the cathode of the organic light emitting diode OLED may be additionally disposed.

In the present disclosure, a power line means at least one of the high power line and the low power line.

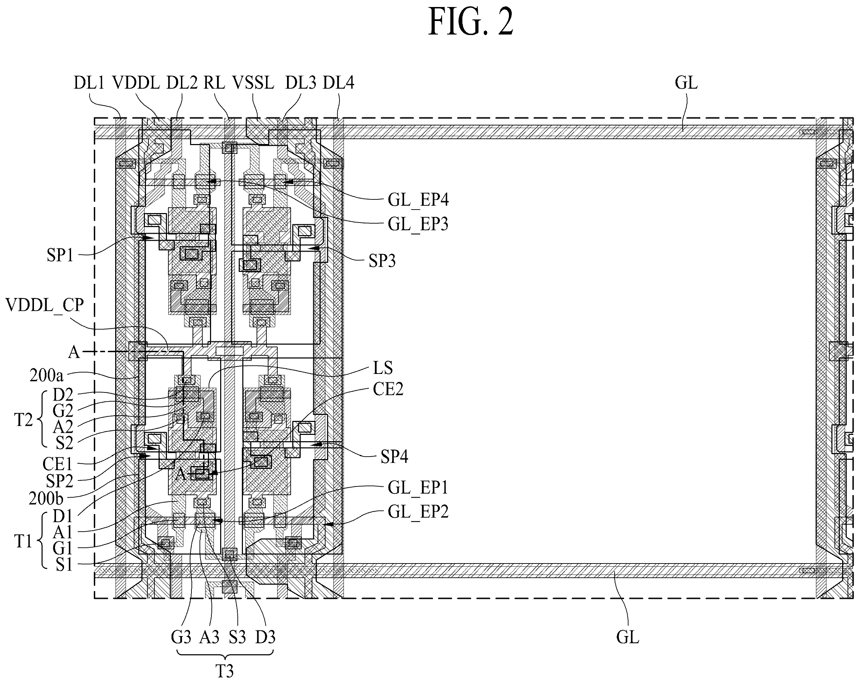

FIG. 2 is a plan view of an electroluminescent display device according to an embodiment of the present disclosure. In FIG. 2, a rectangular shape illustrates a contact hole disposed in the insulating layer so that two overlapping components with the insulating layer therebetween may be electrically connected to each other, which is the same in the following embodiment.

As shown in FIG. 2, a plurality of gate lines GLs are arranged in the first direction, for example, in the horizontal direction.

A plurality of gate line extension parts GL_EP1, GL_EP2, GL_EP3, and GL_EP4 are connected to each of the plurality of gate lines GLs. At least a part of the gate line extension part GL_EP1, GL_EP2, GL_EP3, and GL_EP4 extend in a direction different from that of the gate line GL. The gate line extension parts GL_EP1, GL_EP2, GL_EP3, and GL_EP4 may be integrally formed with the gate line GL.

A first gate line extension part GL_EP1 and a second gate line extension part GL_EP2 may extend upward from one gate line GL, and a third gate line extension part GL_EP3 and a fourth gate line extension part GL_EP4 may extend downward from one gate line GL.

For convenience, in FIG. 2, only the third and fourth gate line extension parts GL_EP3 and GL_EP4 are extended to an upper gate line GL, and only the first and second gate line extensions GL_EP1 and GL_EP2 are extended to a lower gate line GL.

The first gate line extension part GL_EP1 may extend upward in the second direction crossing the first direction at one side of the gate line GL, for example, in the vertical direction, and then may extend again to a right along the first direction.

The second gate line extension part GL_EP2 may extend upward in the second direction from the other side of the gate line GL, and then may extend to a left along the first direction.

One end of the first gate line extension part GL_EP1 and one end of the second gate line extension part GL_EP2 may be spaced apart from each other while facing each other with the reference line RL interposed therebetween, and thus, aperture ratio, sharpness, and transparency may be improved compared to a case where they are connected to each other. However, the present disclosure is not necessarily limited thereto, and the first gate line extension part GL_EP1 and the second gate line extension part GL_EP2 may be connected to each other.

The third gate line extension part GL_EP3 may extend downward in the second direction crossing the first direction at one side of the gate line GL, for example, in the vertical direction, and then may extend again to the right along the first direction.

The fourth gate line extension part GL_EP4 may extend downward in the second direction from the other side of the gate line GL and then may extend to the left again along the first direction.

One end of the third gate line extension part GL_EP3 and one end of the fourth gate line extension part GL_EP4 may be spaced apart from each other while facing each other with the reference line RL interposed therebetween, and thus, aperture ratio, sharpness, and transparency may be improved compared to a case where they are connected to each other. However, the present disclosure is not limited thereto, and the third gate line extension part GL_EP3 and the fourth gate line extension part GL_EP4 may be connected to each other.

The gate line extension parts GL_EP1, GL_EP2, GL_EP3, and GL_EP4 may be disposed in separate sub-pixels.

The first gate line extension part GL_EP1 may supply a gate signal to the second sub-pixel SP2, the second gate line extension part GL_EP2 may supply a gate signal to the fourth sub-pixel SP4, the third gate line extension part GL_EP3 may supply a gate signal to the first sub-pixel SP1, and the fourth gate line extension part GL_EP4 may supply a gate signal to the third sub-pixel SP3.

A high power line VDDL, a low power line VSSL, data lines DL1, DL2, DL3, and DL4 and a reference line RL are arranged in a second direction crossing the first direction, for example, in a vertical direction.

In the second direction, a first data line DL1, a second data line DL2, the reference line RL, a third data line DL3, and a fourth data line DL4 are arranged in order, and the arrangement may be repeated, but is not limited thereto.

The high power line VDDL may overlap the first data line DL1 and the second data line DL2, and the low power line VSSL may overlap the third data line DL3 and the fourth data line DL4.

The high power line VDDL may be connected to a high power line connection part VDDL_CP. The high power line connection part VDDL_CP is connected to the high power line VDDL through a contact hole and extends from the high power line VDDL in the first direction. The high power VDD may be supplied to the plurality of sub-pixels SP1, SP2, SP3, and SP4 through the high power line connection part VDDL_CP.

The data lines DL1, DL2, DL3, and DL4 and the reference line RL may be formed of the same material on the same layer. The data lines DL1, DL2, DL3, and DL4 and the reference line RL may be positioned below the gate line GL with an insulating layer therebetween.

The high power line VDDL and the low power line VSSL may be made of the same material on the same layer. The high power line VDDL and the low power line VSSL may be positioned above the gate line GL with an insulating layer therebetween.

The high power line connection part VDDL_CP may be made of the same material on the same layer as the gate line GL.

Two sub-pixels SP1 and SP2 are disposed in the vertical direction between the high power line VDDL and the reference line RL or between the second data line DL2 and the reference line RL. In this case, the two sub-pixels SP1 and SP2 may include a first sub-pixel SP1 and a second sub-pixel SP2 separated from each other with the high power line connection part VDDL_CP interposed therebetween. For example, the two sub-pixels SP1 and SP2 may include a first sub-pixel SP1 disposed above the high power line connection part VDDL_CP and a second sub-pixel SP2 disposed below the high power line connection part VDDL_CP.

In addition, two sub-pixels SP3 and SP4 different in the vertical direction are disposed between the reference line RL and the low power line VSSL or between the low power line VSSL and the third data line DL3. In this case, the other two sub-pixels may include a third sub-pixel SP3 disposed above the high power line connection part VDDL_CP and a fourth sub-pixel SP4 disposed below the high power line connection part VDDL_CP.

In this case, the first sub-pixel SP1 faces the third sub-pixel SP3 with the reference line RL interposed therebetween, and the second sub-pixel SP2 faces the fourth sub-pixel SP4 with the reference line RL interposed therebetween.

Accordingly, four sub-pixels SP1, SP2, SP3, and SP4 may be formed by the high power line VDDL, the reference line RL, and the low power line VSSL arranged in the second direction and the high power line connection unit VDDL_CP arranged in the first direction.

Each of the sub-pixels SP1, SP2, SP3, and SP4 may include a light emitting area, a line area, and a circuit area. In this case, the light emitting area may overlap at least a portion of the line area and the circuit area, and in this case, the electroluminescent display device may be configured in a top emission type.

Throughout the present disclosure, the light emitting area is an area in which light emission occurs, the line area is an area in which lines including the high power line VDDL, the data lines DL1, DL2, DL3, and DL4, the reference line RL, the gate line GL, and the scan control line SCL are disposed, and the circuit area is an area in which thin film transistors T1, T2, and T3 and a capacitor are disposed.

A transmissive area through which external light is transmitted may be disposed on one side, for example, a right side of the sub-pixels SP1, SP2, SP3, and SP4. The transmissive area may be defined by the fourth data line DL4 of one pixel, the first data line DL1 of another pixel, and two upper and lower gate lines GL.

The first data line DL1 and the second data line DL2 may be disposed adjacent to each other without other wirings being disposed therebetween. The third data line DL3 and the fourth data line DL4 may also be disposed adjacent to each other without other wirings being disposed therebetween.

The first data line DL1 supplies a data signal to the first sub-pixel SP1, the second data line DL2 supplies a data signal to the second sub-pixel SP2, the third data line DL3 supplies a data signal to the third sub-pixel SP3, and the fourth data line DL4 supplies a data signal to the fourth sub-pixel SP4.

Meanwhile, according to another embodiment of the present disclosure, since the second data line DL2 is disposed at a left side of the reference line RL while being adjacent to the reference line RL, and the third data line DL3 is disposed at a right side of the reference line RL while being adjacent to the reference line RL, the first sub-pixel SP1 and the second sub-pixel SP2 are disposed between the first data line DL1 and the second data line DL2, and the third sub-pixel SP3 and the fourth sub-pixel SP4 may be disposed between the third data line DL3 and the fourth data line DL4.

According to another embodiment of the present disclosure, the high power line VDDL is disposed at a left side of the first data line DL1, the low power line VSSL is disposed at a right side of the fourth data line DL4, the second data line DL2 is disposed at a left side of the reference line RL while being adjacent to the reference line RL, and the third data line DL3 is disposed at a right side of the reference line RL while being adjacent to the reference line RL. The first sub-pixel SP1 and the second sub-pixel SP2 are disposed between the first data line DL1 and the second data line DL2, and the third sub-pixel SP3 and the fourth sub-pixel SP4 may be disposed between the third data line DL3 and the fourth data line DL4, and in this case, the high power line VDDL and the low power line VSSL may be formed of the same material in the same layer as the data lines DL1, DL2, DL3, and DL4 without overlapping the data lines DL1, DL2, DL3, and DL4.

A switching thin film transistor T1, a driving thin film transistor T2, and a sensing thin film transistor T3 are disposed in the circuit area of each of the four sub-pixels SP1, SP2, SP3, and SP4.

The switching thin film transistor T1 includes a first gate electrode G1, a first source electrode S1, a first drain electrode D1, and a first active layer A1.

The first gate electrode G1 may be formed of a part of the gate line extension parts GL_EP1, GL_EP2, GL_EP3, and GL_EP4.

The first source electrode S1 may be connected to a portion branched from the data lines DL1, DL2, DL3, and DL4 through a contact hole, and may be connected to one end of the first active layer A1 through a contact hole.

The first drain electrode D1 may be disposed on the same layer as the first source electrode S1, and may be connected to the other end of the first active layer A1 through a contact hole.

The first source electrode S1 and the first drain electrode D1 may be formed of the same material as the first gate electrode G1, but are not limited thereto.

The first active layer A1 may be connected to the first source electrode S1 and the first drain electrode D1 through a contact hole, respectively, to function as an electron moving channel.

The driving thin film transistor T2 includes a second gate electrode G2, a second source electrode S2, a second drain electrode D2, and a second active layer A2.

The second gate electrode G2 may be connected to the first drain electrode D1 of the switching thin film transistor T1. The second gate electrode G2 may be integrally formed with the first drain electrode D1, but is not limited thereto.

The second source electrode S2 may be connected to one end of the second active layer A2 through a contact hole while facing the second drain electrode D2. The second source electrode S2 may be connected to a light blocking layer LS thereunder through a contact hole.

The light blocking layer LS may be formed of the same material in the same layer as the data lines DL1, DL2, DL3, and DL4, and the reference line RL. The light blocking layer LS may overlap the second active layer A2 to block external light from being incident on the second active layer A2. In addition, the light blocking layer LS may function as a capacitor electrode. Specifically, the light blocking layer LS and the second gate electrode G2 may overlap each other with an insulating layer therebetween, so that a capacitor may be formed by the light blocking layer LS and the second gate electrode G2.

The second source electrode S2 may be connected to the two connection electrodes CE1 and CE2 through a contact hole. The two connection electrodes CE1 and CE2 may be disposed on the second source electrode S2 with an insulating layer therebetween. For example, the two connection electrodes CE1 and CE2 may be formed of the same material on the same layer as the high power line VDDL and the low power line VSSL.

A first connection electrode CE1 may be connected to a first sub-electrode 200a that functions as one anode through a contact hole, and a second connection electrode CE2 may be connected to a second sub-electrode 200b that functions as the other anode through a contact hole. Accordingly, the first electrodes 200a and 200b of one sub-pixel may be formed of two sub-electrodes 200a and 200b that are spaced apart from each other. The two sub-electrodes 200a and 200b may be driven at the same time, or only one sub-electrode 200a and 200b may be driven by a repair process for solving defects.

The second drain electrode D2 may face the second source electrode S2 and may be connected to the other end of the second active layer A2 through a contact hole.

The second drain electrode D2 is connected to the high power line VDDL through a high power line connection part VDDL_CP. The high power line connection part VDDL_CP is connected to the high power line VDDL through a contact hole. The high power line connection part VDDL_CP may extend in the first direction and may be connected to the second drain electrode D2 of four subpixels. The high power line connection part VDDL_CP and the second drain electrode D2 may be integrally formed.

The second source electrode S2 and the second drain electrode D2 may be formed of the same material as the second gate electrode G2, but are not limited thereto.

In some cases, a configuration connected to the high power line VDDL through the high power line connection part VDDL_CP may function as a source electrode, and a configuration connected to the first electrodes 200a and 200b through the connection electrodes CE1 and CE2 may function as a drain electrode.

The second active layer A2 may be connected to the second source electrode S2 and the second drain electrode D2 through a contact hole, respectively, to function as an electron moving channel. The second active layer A2 may be formed of the same material on the same layer as the first active layer A1.

The sensing thin film transistor T3 includes a third gate electrode G3, a third source electrode S3, a third drain electrode D3, and a third active layer A3.

The third gate electrode G3 may be formed of a part of the gate line extension parts GL_EP1, GL_EP2, GL_EP3, and GL_EP4.

The third source electrode S3 may be integrally formed with the second source electrode S2 of the driving thin film transistor T2. Alternatively, the third source electrode S3 may be connected to the light blocking layer LS through a contact hole, and thus may be electrically connected to the second source electrode S2 of the driving thin film transistor T2 through the light blocking layer LS. The third source electrode S3 may be connected to one end of the third active layer A3 through a contact hole.

The third drain electrode D3 may be formed of the same material on the same layer as the third source electrode S3, and may be connected to the other end of the third active layer A3 through a contact hole. In addition, the third drain electrode D3 may be connected to the reference line RL through a contact hole.

The third active layer A3 may be connected to the third source electrode S3 and the third drain electrode D3 through a contact hole, respectively, to function as an electron moving channel. The third active layer A3 may be formed of the same material on the same layer as the first active layer A1.

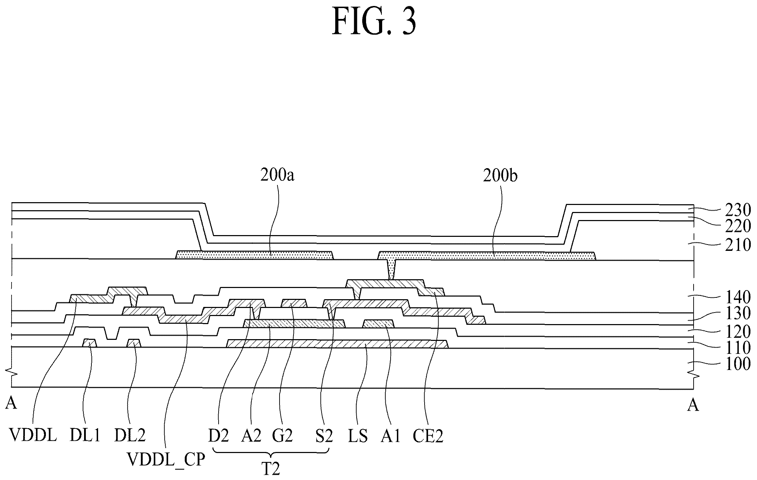

FIG. 3 is a cross-sectional view of an electroluminescent display device according to an embodiment of the present disclosure, which corresponds to a cross-section taken along line A-A of FIG. 2.

As shown in FIG. 3, the data lines DL1 and DL2 and the light blocking layer LS are disposed on the substrate 100 to be spaced apart from each other.

The substrate 100 may be made of glass or plastic, but is not limited thereto. The electroluminescent display device according to an embodiment of the present disclosure may be made of a bottom emission type, and accordingly, a transparent material may be used as a material of the substrate 100.

The data lines DL1 and DL2 and the light blocking layer LS may be patterned through the same process in the same layer using the same material.

A first insulating layer 110 is disposed on the data lines DL1 and DL2 and the light blocking layer LS.

The first insulating layer 110 may be disposed on an entire surface of the substrate 100 except for the contact hole area. The first insulating layer 110 may be formed of an inorganic insulating material.

A second active layer A2 and a first active layer A1 are disposed on the first insulating layer 110.

The second active layer A2 and the first active layer A1 may be formed of the same material through the same process in the same layer.

At least a portion of the second active layer A2 and the first active layer A1 may overlap the light blocking layer LS, so that light entering under the substrate 100 may be blocked by the light blocking layer LS to prevent the light from entering at least a portion of the second active layer A2 and the first active layer A1.

A second insulating layer 120 is disposed on the second active layer A2 and the first active layer A1.

The second insulating layer 120 may be disposed on the entire surface of the substrate 100 except for a contact hole area. However, the present disclosure is not limited thereto, and the second insulating layer 120 may be formed in the same pattern as a high power line connection part VDDL_CP, a second drain electrode D2, a second gate electrode G2, and a second source electrode S2 except for the contact hole area.

The second insulating layer 120 may be made of an inorganic insulating material.

The high power line connection part VDDL_CP, the second drain electrode D2, the second gate electrode G2, and the second source electrode S2 are disposed on the second insulating layer 120 to be spaced apart from each other.

The high power line connection part VDDL_CP may be integrally formed with the second drain electrode D2.

The second drain electrode D2 overlaps the second active layer A2, and is connected to one end of the second active layer A2 through a contact hole disposed in the second insulating layer 120.

The second gate electrode G2 overlaps the second active layer A2, and is disposed in an area between the second drain electrode D2 and the second source electrode S2.

The second source electrode S2 overlaps the second active layer A2, and is connected to the other end of the second active layer A2 through a contact hole disposed in the second insulating layer 120. The second source electrode S2 may overlap the first active layer A1, but is not connected to the first active layer A1.

The high power line connection part VDDL_CP, the second drain electrode D2, the second gate electrode G2, and the second source electrode S2 may be patterned through the same process in the same layer of the same material.

A third insulating layer 130 may be disposed on the high power source line connection part VDDL_CP, the second drain electrode D2, the second gate electrode G2, and the second source electrode S2.

The third insulating layer 130 may be disposed on an entire surface of the substrate 100 except for a contact hole area. The third insulating layer 130 may be made of an inorganic insulating material.

A high power line VDDL and a second connection electrode CE2 are disposed on the third insulation layer 130.

The high power line VDDL and the second connection electrode CE2 may be patterned using the same material through the same process in the same layer.

The high power line VDDL may be connected to the high power line connection part VDDL_CP through a contact hole disposed in the third insulating layer 130, and the second connection electrode CE2 may be connected to the second source electrode S2 through a contact hole disposed in the third insulating layer 130.

Thus, the high power line VDDL overlaps the high power line connection part VDDL_CP, and the second connection electrode CE2 overlaps the second source electrode S2.

A fourth insulating layer 140 is disposed on the high power source line VDDL and the second connection electrode CE2. The fourth insulating layer 140 may include a planarization layer made of an organic insulating material. The fourth insulating layer 140 may be formed of a plurality of insulating layers, and for example, may have a two-layer structure including a passivation layer made of an inorganic material and a planarization layer made of an organic material.

A first electrode 200a and 200b and a bank 210 are disposed on the fourth insulation layer 140.

Each of the first electrodes 200a and 200b may include a first sub-electrode 200a and a second sub-electrode 200b that are spaced apart from each other while functioning as an anode. The second sub-electrode 200b is connected to the second connection electrode CE2 through a contact hole disposed on the fourth insulation layer 140. Therefore, the second sub-electrode 200b is electrically connected to the second source electrode S2 through the second connection electrode CE2. In some cases, the second sub-electrode 200b may be electrically connected to the second drain electrode D2 through the second connection electrode CE2.

The first electrodes 200a and 200b may include reflective electrodes. Accordingly, light emitted from the light emitting layer 220 may be reflected from the first electrodes 200a and 200b and may proceed in an upward direction.

The bank 210 is disposed on the fourth insulation layer 140 while covering both ends of the first electrode 200a and 200b. A portion of the first electrode 200a and 200b exposed without being covered by the bank 210 may be a light emitting area.

Although not illustrated, the bank 210 may be formed to additionally cover a spaced area between the first sub-electrode 200a and the second sub-electrode 200b.

A light emitting layer 220 is disposed on the first electrodes 200a and 200b and the bank 210, and a second electrode 230 is disposed on the light emitting layer 220.

The light emitting layer 220 may be continuous without being disconnected between the plurality of sub-pixels, and in this case, the light emitting layer 200 may emit white light. The light emitting layer 220 emitting white light may include a stack including a blue light emitting layer and a stack including a yellow green light emitting layer. The light emitting layer 200 emitting white light may include a stack including a blue light emitting layer, a stack including a green light emitting layer, and a stack including a red light emitting layer.

The light emitting layer 220 may include a blue light emitting layer, a green light emitting layer, and a red light emitting layer patterned for each of the plurality of sub-pixels.

The second electrode 230 may function as a cathode. The second electrode 230 may include a transparent electrode or a translucent electrode. Accordingly, the light emitted from the light emitting layer 220 may pass through the second electrode 230 and proceed in an upward direction. The second electrode 230 may be entirely formed on the plurality of sub-pixels and a boundary therebetween.

In addition, as in the above-described embodiment, an encapsulation layer, a color filter, and a touch sensor may be additionally configured on the second electrode 230.

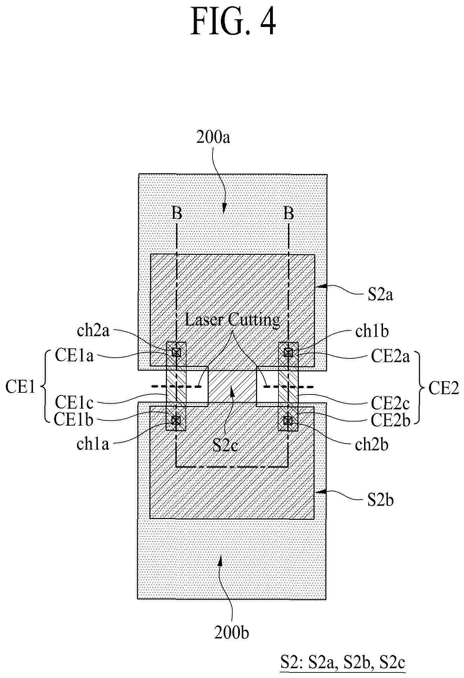

FIG. 4 is a plan view of an electroluminescent display device according to an embodiment of the present disclosure, which illustrates an electrical connection between a second source electrode S2 of a driving thin film transistor T2 and a first electrode 200a and 200b functioning as an anode of one sub-pixel. Although not shown, the source electrode S2 of the driving thin film transistor T2 may be replaced with the drain electrode D2.

As shown in FIG. 4, a first sub-electrode 200a and a second sub-electrode 200b are spaced apart from each other in the second direction, for example, in the vertical direction.

The second source electrode S2 is formed to overlap each of the first sub-electrode 200a and the second sub-electrode 200b. The second source electrode S2 may extend from an area overlapping the first sub-electrode 200a to an area overlapping the second sub-electrode 200b.

The second source electrode S2 includes a first part S2a overlapping the first sub-electrode 200a, a second part S2b overlapping the second sub-electrode 200b, and a third part S2c connecting the first part S2a and the second part S2b.

The third part S2c is a part formed in an area where the first sub-electrode 200a and the second sub-electrode 200b are spaced apart from each other, and may not overlap the first sub-electrode 200a and the second sub-electrode 200b.

A width of the third part S2c in the first direction, for example, in the horizontal direction, may be less than a width of the first part S2a in the first direction and a width of the second part S2b in the first direction. Accordingly, the first part S2a and the second part S2b may overlap the first connection electrode CE1 and the second connection electrode CE2, but the third part S2c may not overlap the first connection electrode CE1 and the second connection electrode CE2.

The first sub-electrode 200a may be connected to the second source electrode S2 by the first connection electrode CE1, and the second sub-electrode 200b may be connected to the second source electrode S2 by the second connection electrode CE2.

One end of the first connection electrode CE1 may be connected to the second source electrode S2 through a first contact hole ch1a, and the other end of the first connection electrode CE1 may be connected to the first sub-electrode 200a through a second contact hole ch2a. The first connection electrode CE1 may extend from an area overlapping the second sub-electrode 200b to an area overlapping the first sub-electrode 200a while formed in the second direction. Accordingly, the first contact hole ch1a may overlap the second sub-electrode 200b, and the second contact hole ch2a may overlap the first sub-electrode 200a.

For example, the first part CE1a of the first connection electrode CE1 may overlap the first sub-electrode 200a, the second part CE1b of the first connection electrode CE1 may overlap the second sub-electrode 200b, and the third part CE1c of the first connection electrode CE1 may not overlap the first sub-electrode 200a and the second sub-electrode 200b while connecting the first part CE1a and the second part CE1b.

In addition, the first part CE1a of the first connection electrode CE1 may overlap the first part S2a of the second source electrode S2, and the second part CE1b of the first connection electrode CE1 may overlap the second part S2b of the second source electrode S2, but the third part CE1c of the first connection electrode CE1 may not overlap an entire part of the second source electrode S2 including the third part S2c of the second source electrode S2. Accordingly, when the third part CE1c of the first connection electrode CE1 is cut by laser irradiation, the second source electrode S2 is not adversely affected by the laser irradiation.

One end of the second connection electrode CE2 may be connected to the second source electrode S2 through the first contact hole ch1b, and the other end of the second connection electrode CE2 may be connected to the second sub-electrode 200b through the second contact hole ch2b. The second connection electrode CE2 may extend from an area overlapping the first sub-electrode 200a to an area overlapping the second sub-electrode 200b while formed in the second direction. Accordingly, the first contact hole ch1b may overlap the first sub-electrode 200a, and the second contact hole ch2b may overlap the second sub-electrode 200b.

For example, the first part CE2a of the second connection electrode CE2 may overlap the first sub-electrode 200a, the second part CE2b of the second connection electrode CE2 may overlap the second sub-electrode 200b, and the third part CE2c of the second connection electrode CE2 may not overlap the first sub-electrode 200a and the second sub-electrode 200b while connecting the first part CE2a and the second part CE2b.

In addition, the first part CE2a of the second connection electrode CE2 may overlap the first part S2a of the second source electrode S2, and the second part CE2b of the second connection electrode CE2 may overlap the second part S2b of the second source electrode S2, but the third part CE2c of the second connection electrode CE2 may not overlap an entire part of the second source electrode S2 including the third part S2c of the second source electrode S2. Accordingly, when the third part CE2c of the second connection electrode CE2 is cut by laser irradiation, the second source electrode S2 is not adversely affected by the laser irradiation.

The third part CE1c of the first connection electrode CE1 and the third part CE2c of the second connection electrode CE2 may be arranged in parallel with each other.

The first contact hole ch1a for electrical connection between one end of the first connection electrode CE1 and the second source electrode S2 may face a second contact hole ch2b for electrical connection between the other end of the second connection electrode CE2 and the second sub-electrode 200b in the first direction, for example, the horizontal direction. In addition, the second contact hole ch2a for electrical connection between the other end of the first connection electrode CE1 and the first sub-electrode 200a may face the first contact hole ch1b for electrical connection between one end of the second connection electrode CE2 and the second source electrode S2 in the first direction.

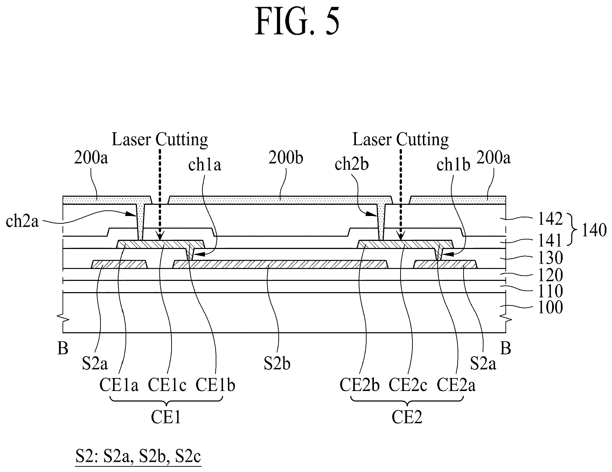

FIG. 5 is a cross-sectional view of an electroluminescent display device according to an embodiment of the present disclosure, which corresponds to a cross-section taken along line B-B of FIG. 4.

As shown in FIG. 5, a first insulating layer 110 is disposed on the substrate 100, and a second insulating layer 120 is disposed on the first insulating layer 110.

A second source electrode S2 is disposed on the second insulating layer 120.

The second source electrode S2 includes a first part S2a and a second part S2b spaced apart from each other.

A third insulating layer 130 is disposed on the second source electrode S2.

A first contact hole ch1a for electrical connection between a first connection electrode CE1 and the second source electrode S2 and a first contact hole ch1b for electrical connection between a second connection electrode CE2 and the second source electrode S2 are disposed in the third insulating layer 130.

The first contact hole ch1a for electrical connection between the first connection electrode CE1 and the second source electrode S2 may overlap the second part S2b of the second source electrode S2, and a first contact hole ch1b for electrical connection between the second connection electrode CE2 and the second source electrode S2 may overlap the first part S2a of the second source electrode S2.

A first connection electrode CE1 and a second connection electrode CE2 are disposed on the third insulation layer 130.

The first connection electrode CE1 is connected to the second source electrode S2 through the first contact hole ch1a, and the second connection electrode CE2 is connected to the second source electrode S2 through the first contact hole ch1b. Specifically, the second part CE1b of the first connection electrode CE1 is connected to the second source electrode S2 through the first contact hole ch1a, and the second part CE2b of the second connection electrode CE2 is connected to the second source electrode S2 through the first contact hole ch1b.

The first connection electrode CE1 and the second connection electrode CE2 may overlap an area spaced apart from the first part S2a and the second part S2b of the second source electrode S2. Specifically, the third part CE1c of the first connection electrode CE1 and the third part CE2c of the second connection electrode CE2 may overlap an area spaced apart from the first part S2a and the second part S2b of the second source electrode S2.

A fourth insulation layer 140 is disposed on the first connection electrode CE1 and the second connection electrode CE2.

The fourth insulating layer 140 may have a two-layer structure of a passivation layer 141 and a planarization layer 142 disposed on the passivation layer 141.

A second contact hole ch2a for electrical connection between the first connection electrode CE1 and a first sub-electrode 200a and a second contact hole ch2b for electrical connection between the second connection electrode CE2 and a second sub-electrode 200b are disposed in the fourth insulation layer 140.

The second contact hole ch2a for electrical connection between the first connection electrode CE1 and the first sub-electrode 200a may overlap the first part S2a of the second source electrode S2, and the second contact hole ch2b for electrical connection between the second connection electrode CE2 and the second sub-electrode 200b may overlap the second part S2b of the second source electrode S2.

A first electrode 200a and 200b are disposed on the fourth insulation layer 140.

The first electrode 200a and 200b may include a first sub-electrode 200a and a second sub-electrode 200b spaced apart from each other.

The first sub-electrode 200a is connected to the first connection electrode CE1 through the second contact hole ch2a, and the second sub-electrode 200b is connected to the second connection electrode CE2 through the second contact hole ch2b. Specifically, the first sub-electrode 200a is connected to the first part CE1a of the first connection electrode CE1 through the second contact hole ch2a, and the second sub-electrode 200b is connected to the second part CE2b of the second connection electrode CE2 through the second contact hole ch2b.

The first sub-electrode 200a may overlap the first contact hole ch1b and the second contact hole ch2a, and the second sub-electrode 200b may overlap the first contact hole ch1a and the second contact hole ch2b.

A spaced area between the first sub-electrode 200a and the second sub-electrode 200b may overlap a spaced area between the first part S2a and the second part S2b of the second source electrode S2.

Although not shown, a light emitting layer 220 and a second electrode 230 are disposed on the first electrode 200a and 200b.

Each of the third part CE1c of the first connection electrode CE1 and the third part CE2c of the second connection electrode CE2 may overlap area separated between the first sub-electrode 200a and the second sub-electrode 200b. Accordingly, when a short defect occurs, the first connection electrode CE1 or the second connection electrode CE2 may be disconnected by irradiating a laser to the third part CE1c of the first connection electrode CE1 or the third part CE2c of the second connection electrode CE2.

For example, when a short defect occurs between wires in an area overlapping the first sub-electrode 200a, the first connection electrode CE1 may be disconnected by irradiating a laser to the third part CE1c of the first connection electrode CE1 through a spaced area between the first sub-electrode 200a and the second sub-electrode 200b.

In this way, when the first connection electrode CE1 is disconnected, the electrical connection between the first sub-electrode 200a and the second source electrode S2 is disconnected, so that light emission does not occur in an area overlapping the first sub-electrode 200a and light emission occurs only in an area overlapping the second sub-electrode 200b. In this case, since the laser is irradiated to a separated area between the first part S2a and the second part S2b of the second source electrode S2, the second source electrode S2 is not adversely affected due to the laser irradiation.

Similarly, when a short defect occurs between wires in an area overlapping the second sub-electrode 200b, the second connection electrode CE2 may be disconnected by irradiating a laser to the third part CE2c of the second connection electrode CE2 through a spaced area between the first sub-electrode 200a and the second sub-electrode 200b.

In this way, when the second connection electrode CE2 is disconnected, the electrical connection between the second sub-electrode 200b and the second source electrode S2 is disconnected, so that light emission does not occur in an area overlapping the second sub-electrode 200b and light emission occurs only in an area overlapping the first sub-electrode 200a. In this case, since the laser is irradiated to a separated area between the first portion S2a and the second portion S2b of the second source electrode S2, the second source electrode S2 is not adversely affected due to the laser irradiation.

Therefore, according to an embodiment of the present disclosure, the first electrode 200a and 200b in one sub-pixel may include the first sub-electrode 200a and the second sub-electrode 200b, the first sub-electrode 200a may be connected to the source electrode S2 or the drain electrode D2 of the driving thin film transistor through the first connection electrode CE1, and the second sub-electrode 200b may be connected to the source electrode S2 or the drain electrode D2 of the driving thin film transistor through the second connection electrode CE2.

Accordingly, when a short defect occurs due to particles, only the first connection electrode CE1 or the second connection electrode CE2 corresponding to the area where the short defect occurs is disconnected, so that an image is not displayed in some areas where the short defect occurs within one sub-pixel, but an image may be displayed in an area where the short defect does not occur.

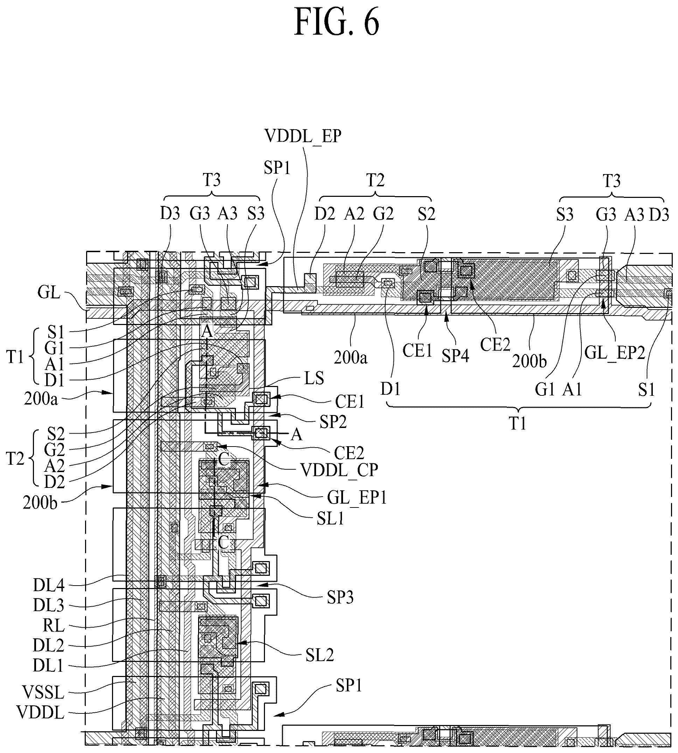

FIG. 6 is a plan view of an electroluminescent display device according to another embodiment of the present disclosure.

As shown in FIG. 6, a plurality of gate lines GLs are arranged in the first direction, for example, in the horizontal direction.

A first gate line extension part GL_EP1 and a second gate line extension part GL_EP2 may extend from the gate line GL. The gate line extension parts GL_EP1 and GL_EP2 may be integrally formed with the gate line GL.

The first gate line extension part GL_EP1 may extend downward from the gate line GL, and the second gate line extension part GL_EP2 may extend upward from the gate line GL.

The first gate line extension part GL_EP1 may include a first portion and a second portion. The first portion is an area extending downward from one side of the gate line GL in the second direction, for example, in the vertical direction, and the second portion is an area extending from the first portion to the left in the first direction, for example, in the horizontal direction. The first gate line extension part GL_EP1 includes a structure in which a combination of the first portion and the second portion is repeated twice, and thus may be extended to a plurality of sub-pixels arranged in the second direction, for example, a third sub-pixel SP3 and a first sub-pixel SP1.

The second gate line extension part GL_EP2 may extend upward in the second direction from the other side of the gate line GL, and thus may extend to another sub-pixel arranged in the first direction, for example, a fourth sub-pixel SP4.

For example, the gate line GL may supply a gate signal to the second sub-pixel SP2, the first gate line extension part GL_EP1 may supply the same gate signal to the third sub-pixel SP3 and the first sub-pixel SP1, and the second gate line extension part GL_EP2 may supply the same gate signal to the fourth sub-pixel SP4. In this case, the first sub-pixel to the third sub-pixel SP1, SP2, and SP3 may be arranged in the second direction, for example, in the vertical direction, and the fourth sub-pixel SP4 may be arranged in the horizontal direction from the right side of the first sub-pixel, for example.

A high power line VDDL, a low power line VSSL, data lines DL1, DL2, DL3, and DL4 and a reference line RL are arranged in a second direction crossing the first direction, for example, in a vertical direction.

In the second direction, a first data line DL1, a second data line DL2, the reference line RL, a third data line DL3, and a fourth data line DL4 are arranged in order, and the arrangement may be repeated, but is not limited thereto.

The first data line DL1 supplies a data signal to the first sub-pixel SP1, the second data line DL2 supplies a data signal to the second sub-pixel SP2, the third data line DL3 supplies a data signal to the third sub-pixel SP3, and the fourth data line DL4 supplies a data signal to the fourth sub-pixel SP4.

The high power line VDDL may be formed to overlap the second data line DL2 and the reference line RL, and the low power line VSSL may be formed to overlap the third data line DL3 and the fourth data line DL4, but is not limited thereto.

The high power line VDDL may be connected to a high power line connection part VDDL_CP. The high power line connection part VDDL_CP is connected to the high power line VDDL through a contact hole and extends from the high power line VDDL in the first direction. The high power VDD may be supplied to a plurality of sub-pixels, for example, the first to third sub-pixels, through the high power source line connection part VDDL_CP.

In addition, a high power line extension part VDDL_EP may extend from the high power line VDDL. The high power line extension part VDDL_EP may extend from the high power line VDDL to the fourth sub-pixel in the first direction. The high power VDD may be supplied to the fourth sub-pixel through the high power line extension part VDDL_EP.

The data lines DL1, DL2, DL3, and DL4 and the reference line RL may be formed of the same material on the same layer. The data lines DL1, DL2, DL3, and DL4 and the reference line RL may be positioned below the gate line GL with an insulating layer therebetween.

The high power line connection part VDDL_CP may be formed of the same material on the same layer as the gate line GL. The high power line extension part VDDL_EP may be integrally formed with the high power line VDDL.

A first sub-pixel SP1 may be disposed above one side of the gate line GL while partially overlapping the gate line GL, and a second sub-pixel SP2 and a third sub-pixel SP3 may be sequentially disposed below the first sub-pixel SP1. In addition, a fourth sub-pixel SP4 may be disposed above the other side of the gate line GL while partially overlapping the gate line GL. The fourth sub-pixel SP4 may face the first sub-pixel SP1.

The first to third sub-pixels SP1, SP2, and SP3 may overlap the high power line VDDL, the low power line VSSL, the data lines DL1, DL2, DL3, and DL4, and the reference line RL.

The fourth sub-pixel SP4 may not overlap the high power line VDDL, the low power line VSSL, the data lines DL1, DL2, DL3, and DL4, and the reference line RL.

Each of the sub-pixels SP1, SP2, SP3, and SP4 may include a light emitting area, a line area, and a circuit area. In this case, the light emitting area may overlap at least a portion of the line area and the circuit area, and in this case, the electroluminescent display device may be configured in a top emission type.

In addition, a right area of the second and third sub-pixels SP2 and SP3 and a lower area of the fourth sub-pixel SP4 may be formed of a transmissive area through which external light may transmit.

The fourth data line DL4 and the third data line DL3 may be disposed adjacent to each other without other wirings being disposed therebetween. The third data line DL3 and the reference line RL may be disposed adjacent to each other without other wirings being disposed therebetween. The reference line RL and the second data line DL2 may be disposed adjacent to each other without other wirings being disposed therebetween. The second data line DL2 and the first data line DL1 may be disposed adjacent to each other without other wirings being disposed therebetween.

According to another embodiment of the present disclosure, the data lines DL1, DL2, DL3, and DL4 and the reference line RL are disposed adjacent to each other, and the high power line VDDL and the low power line VSSL are disposed adjacent to each other to overlap the data lines DL1, DL2, DL3, and DL4 and the reference line RL.

Thus, according to another embodiment of the present disclosure, various lines are adjacent to each other to form the line area, and the circuit area including a plurality of thin film transistors T1, T2, and T3 is arranged to be adjacent to the line area, thereby reducing the total size of the line area and the circuit area. Accordingly, a resolution can be increased by reducing a size of the light emitting area, and a size of the transmissive area can also be increased.

A switching thin film transistor T1, a driving thin film transistor T2, and a sensing thin film transistor T3 are disposed in the circuit area of each of the four sub-pixels SP1, SP2, SP3, and SP4.

The switching thin film transistor T1 includes a first gate electrode G1, a first source electrode S1, a first drain electrode D1, and a first active layer A1.

The first gate electrode G1 of the second sub-pixel SP2 may include a part of the gate line GL, the first gate electrode G1 of the first sub-pixel SP1 and the third sub-pixel SP3 may include a part of the first gate line extension part GL_EP1, more specifically a part of the second portion of the first gate line extension part GL_EP1 extending in the horizontal direction, and the first gate electrode G1 of the fourth sub-pixel SP4 may include a portion of the second gate line extension part GL_EP4.

The first source electrode S1 may be connected to the data lines DL1, DL2, DL3, and DL4 through a contact hole, and may be connected to one end of the first active layer A1 through a contact hole.

The first drain electrode D1 may be disposed on the same layer as the first source electrode S1, and may be connected to the other end of the first active layer A1 through a contact hole.

The first source electrode S1 and the first drain electrode D1 may be formed of the same material as the first gate electrode G1, but are not limited thereto.

The first active layer A1 may be connected to the first source electrode S1 and the first drain electrode D1 through a contact hole, respectively, to function as an electron moving channel.

The driving thin film transistor T2 includes a second gate electrode G2, a second source electrode S2, a second drain electrode D2, and a second active layer A2.

The second gate electrode G2 may be connected to the first drain electrode D1 of the switching thin film transistor T1. The second gate electrode G2 may be integrally formed with the first drain electrode D1, but is not limited thereto.

The second source electrode S2 may be connected to one end of the second active layer A2 through a contact hole. The second source electrode S2 may be connected to a light blocking layer LS thereunder through a contact hole.

The light blocking layer LS may be formed of the same material in the same layer as the data lines DL1, DL2, DL3, and DL4, and the reference line RL. The light blocking layer LS may overlap the second active layer A2 to block external light from being incident on the second active layer A2. In addition, the light blocking layer LS may function as a capacitor electrode. Specifically, the light blocking layer LS and the second gate electrode G2 may overlap each other with an insulating layer therebetween, so that a capacitor may be formed by the light blocking layer LS and the second gate electrode G2.

The second source electrode S2 may be connected to two connection electrodes CE1 and CE2 through contact holes. The two connection electrodes CE1 and CE2 may be formed of the same material on the same layer as the high power line VDDL and the low power line VSSL.

Like the first to third sub-pixels SP1, SP2, and SP3, a first connection electrode CE1 may be connected to the second source electrode S2 through a contact hole, and a second connection electrode CE1 may be branched from the first connection electrode CE1. In addition, like the fourth sub-pixel SP4, each of the first connection electrode CE1 and the second connection electrode CE2 may be connected to the second source electrode S2 through a contact hole.

The first connection electrode CE1 may be connected to a first sub-electrode 200a that functions as one anode through a contact hole, and the second connection electrode CE2 may be connected to a second sub-electrode 200b that functions as the other anode through a contact hole. Accordingly, the first electrodes 200a and 200b of one sub-pixel may be formed of two sub-electrodes 200a and 200b that are spaced apart from each other. The two sub-electrodes 200a and 200b may be driven at the same time, or only one sub-electrode 200a and 200b may be driven by a repair process for solving defects.

The second drain electrode D2 may be connected to the other end of the second active layer A2 through a contact hole.

Like the first to third subpixels SP1, SP2, and SP3, the second drain electrode D2 may be connected to the high power line VDDL through a high power line connection part VDDL_CP. The high power line connection part VDDL_CP is connected to the high power line VDDL through a contact hole. The high power line connection part VDDL_CP may be connected to the second drain electrode D2 of the first to third subpixels SP1, SP2, and SP3 while extending in the first direction. The high power line connection part VDDL_CP and the second drain electrode D2 may be integrally formed.

Like the fourth sub-pixel SP4, the second drain electrode D2 may be connected to the high power line VDDL through a high power line extension part VDDL_EP. The high power line extension part VDDL_EP may be integrally formed with the high power line VDDL. The high power line extension part VDDL_EP may be connected to the second drain electrode D2 through a contact hole.

The second source electrode S2 and the second drain electrode D2 may be formed of the same material as the second gate electrode G2, but are not limited thereto.

In some cases, a configuration connected to the high power line VDDL through the high power line connection part VDDL_CP or the high power line extension part VDDL_EP may function as a source electrode, and a configuration connected to the first electrodes 200a and 200b through the connection electrodes CE1 and CE2 may function as a drain electrode.

The second active layer A2 may be connected to the second source electrode S2 and the second drain electrode D2 through a contact hole, respectively, to function as an electron moving channel. The second active layer A2 may be formed of the same material on the same layer as the first active layer A1.

The sensing thin film transistor T3 includes a third gate electrode G3, a third source electrode S3, a third drain electrode D3, and a third active layer A3.

The third gate electrode G3 of the second sub-pixel SP2 may include a portion of the gate line GL, the third gate electrode G3 of the first sub-pixel SP1 and the third sub-pixel SP3 may include a portion of the first gate line extension part GL_EP1, specifically a portion of the second portion of the first gate line extension part GL_EP1, and the third gate electrode G3 of the fourth sub-pixel SP4 may include a portion of the second gate line extension part GL_EP4.

The third source electrode S3 may be integrally formed with the second source electrode S2 of the driving thin film transistor T2. Alternatively, the third source electrode S3 may be connected to the light blocking layer LS through a contact hole, and thus may be electrically connected to the second source electrode S2 of the driving thin film transistor T2 through the light blocking layer LS.

The third source electrode S3 may be connected to one end of the third active layer A3 through a contact hole.

The third drain electrode D3 may be formed of the same material on the same layer as the third source electrode S3, and may be connected to the other end of the third active layer A3 through a contact hole. In addition, the third drain electrode D3 may be connected to the reference line RL through a contact hole. One third drain electrode D3 may be shared in the first sub-pixel SP1, the second sub-pixel SP2, and the fourth sub-pixel SP4, and a separate third drain electrode D3 that is not shared with the other sub-pixels SP1, SP2, and SP4 may be disposed in the third sub-pixel SP3.

The third active layer A3 may be connected to the third source electrode S3 and the third drain electrode D3 through a contact hole, respectively, to function as an electron moving channel. The third active layer A3 may be formed of the same material on the same layer as the first active layer A1.

According to another embodiment of the present disclosure, the thin film transistors T1, T2, and T3 may be formed in the first to third sub-pixels SP1, SP2, and SP3 at the highest density possible. Accordingly, a size of the circuit area may be minimized. In addition, a resolution may be improved by reducing sizes of the first to third sub-pixels SP1, SP2, and SP3.

For example, according to another embodiment of the present disclosure, since the thin film transistors T1, T2, and T3 are formed in a high density in the plurality of sub-pixels SP1, SP2, and SP3, at least a portion of the thin film transistors T1, T2, and T3 of one sub-pixel may be formed to overlap the other sub-pixel SP1, SP2, and SP3 areas adjacent thereto.

For example, at least a portion of the switching thin film transistor T1 of the second sub-pixel SP2 may be formed to overlap the first sub-pixel SP1. Alternatively, at least a portion of the sensing thin film transistor T3 of the second sub-pixel SP2 may be formed to overlap the first sub-pixel SP1.

Alternatively, at least a portion of the driving thin film transistor T2 of the third sub-pixel SP3 may be formed to overlap an area of the second sub-pixel SP2. Alternatively, at least a portion of the driving thin film transistor T2 of the first sub-pixel SP1 may be formed to overlap an area of the third sub-pixel SP3.

On the other hand, when at least a portion of one sub-pixel driving thin film transistor T2 overlaps with another sub-pixel area adjacent thereto, a parasitic capacitance is generated between the driving thin film transistor T2 of one sub-pixel and the first electrodes 200a and 200b of the other sub-pixel, for example, the second sub-electrode 200b.

For example, when at least a portion of the driving thin film transistor T2 of the third sub-pixel SP3 overlaps an area of the second sub-pixel SP2, a parasitic capacitance may be generated between the driving thin film transistor T2 of the third sub-pixel SP3 and the second sub-electrode 200b of the second sub-pixel SP2. Accordingly, a gate voltage of the driving thin film transistor T2 of the third sub-pixel SP3 increases, and when the third sub-pixel SP3 emits light, a luminance increases, resulting in a gray scale defect.

Accordingly, according to another embodiment of the present disclosure, in order to prevent the parasitic capacitance, shielding layers SL1 and SL2 may be additionally disposed in an area in which at least a portion of the driving thin film transistor T2 of the one sub-pixel overlaps another sub-pixel area adjacent thereto. For example, a first shielding layer SL1 may be additionally disposed on at least a portion of the driving thin film transistor T2 of the third sub-pixel SP3 overlapping an area of the second sub-pixel SP2, and a second shielding layer SL2 may be additionally disposed on at least a portion of the driving thin film transistor T2 of the first sub-pixel SP1 overlapping an area of the third sub-pixel SP3.

The shielding layers SL1 and SL2 may be patterned simultaneously with the same material on the same layer as the connection electrodes CE1 and CE2. However, the present disclosure is not limited thereto, and the shielding layers SL1 and SL2 may be disposed above the connection electrodes CE1 and CE2.

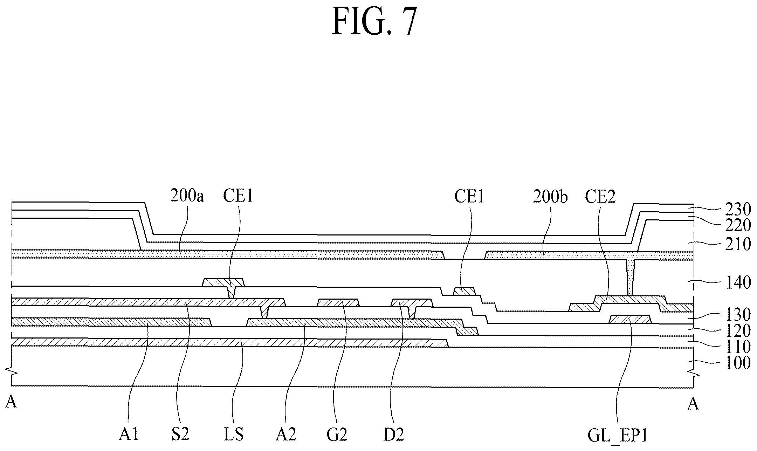

FIG. 7 is a cross-sectional view of an electroluminescent display device according to another embodiment of the present disclosure, which corresponds to a cross-section taken along line A-A of FIG. 6

As shown in FIG. 7, a light blocking layer LS is disposed on the substrate 100.

The substrate 100 may be made of glass or plastic, but is not limited thereto. The electroluminescent display device according to an embodiment of the present disclosure may be made of a top emission type, and accordingly, a transparent material may be used as a material of the substrate 100.

A first insulating layer 110 is disposed on the light blocking layer LS. The first insulating layer 110 may be formed of an inorganic insulating material.

A second active layer A2 and a first active layer A1 are disposed on the first insulating layer 110.

At least a portion of the second active layer A2 and the first active layer A1 may overlap the light blocking layer LS, so that light entering under the substrate 100 may be blocked by the light blocking layer LS to prevent the light from entering at least a portion of the second active layer A2 and the first active layer A1.

A second insulating layer 120 is disposed on the second active layer A2 and the first active layer A1.

The second insulating layer 120 may be disposed on the entire surface of the substrate 100 except for a contact hole area. However, the present disclosure is not limited thereto, and the second insulating layer 120 may be formed in the same pattern as the second source electrode S2, the second gate electrode G2, the second drain electrode D2, and the first gate line extension part GL_EP except for the contact hole area.

The second insulating layer 120 may be made of an inorganic insulating material.

A second source electrode S2, a second gate electrode G2, a second drain electrode D2, and a first gate line extension portion GL_EP are disposed on the second insulating layer 120 to be spaced apart from each other.

The second source electrode S2 overlaps the second active layer A2, and is connected to one end of the second active layer A2 through a contact hole disposed in the second insulating layer 120. The second source electrode S2 may overlap the first active layer A1, but is not connected to the first active layer A1.

The second gate electrode G2 overlaps the second active layer A2, and is disposed in an area between the second drain electrode D2 and the second source electrode S2.

The second drain electrode D2 overlaps the second active layer A2, and is connected to the other end of the second active layer A2 through a contact hole disposed in the second insulating layer 120.

The first gate line extension part GL_EP may be disposed not to overlap the first active layer A1 and the second active layer A2.

The second source electrode S2, the second gate electrode G2, the second drain electrode D2, and the first gate line extension part GL_EP may be patterned using the same material through the same process in the same layer.

A third insulating layer 130 may be disposed on the second source electrode S2, the second gate electrode G2, the second drain electrode D2, and the first gate line extension part GL_EP.

The third insulating layer 130 may be disposed on an entire surface of the substrate 100 except for a contact hole area. The third insulating layer 130 may be made of an inorganic insulating material.

A first connection electrode CE1 and a second connection electrode CE2 are disposed on the third insulation layer 130.

The first connection electrode CE1 and the second connection electrode CE2 may be patterned using the same material through the same process in the same layer.

The first connection electrode CE1 may be connected to the second source electrode S2 through a contact hole disposed in the third insulating layer 130.

The second connection electrode CE2 may overlap the first gate line extension part GL_EP.

A fourth insulation layer 140 is disposed on the first connection electrode CE1 and the second connection electrode CE2.

The fourth insulating layer 140 may include a planarization layer made of an organic insulating material. The fourth insulating layer 140 may be formed of a plurality of insulating layers, and for example, may have a two-layer structure including a passivation layer made of an inorganic material and a planarization layer made of an organic material.

A first electrode 200a and 200b and a bank 210 are disposed on the fourth insulation layer 140.

Each of the first electrodes 200a and 200b may include a first sub-electrode 200a and a second sub-electrode 200b that are spaced apart from each other while functioning as an anode. The second sub-electrode 200b is connected to the second connection electrode CE2 through a contact hole disposed on the fourth insulation layer 140.

The first electrodes 200a and 200b may include reflective electrodes. Accordingly, light emitted from the light emitting layer 220 may be reflected from the first electrodes 200a and 200b and may proceed in an upward direction.

A bank 210 is disposed on the first electrodes 200a and 200b, a light emitting layer 220 is disposed on the bank 210, and a second electrode 230 is disposed on the light emitting layer 220.

The bank 210, the light emitting layer 220, and the second electrode 230 are the same as those in the above-described embodiment.

In addition, as in the above-described embodiment, an encapsulation layer, a color filter, and a touch sensor may be additionally configured on the second electrode 230.

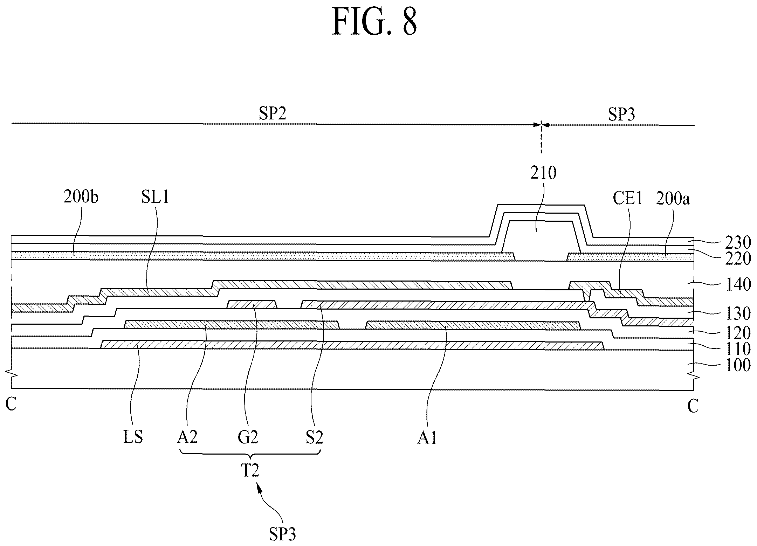

FIG. 8 is a cross-sectional view of an electroluminescent display device according to another embodiment of the present disclosure, which corresponds to a cross section taken along line C-C of FIG. 6.

As can be seen from FIG. 8, a light blocking layer LS is disposed on the substrate 100, and a first insulating layer 110 is disposed on the light blocking layer LS.

A second active layer A2 and a first active layer A1 are disposed on the first insulating layer 110, and a second insulating layer 120 is disposed on the second active layer A2 and the first active layer A1.

A second gate electrode G2 and a second source electrode S2 may be disposed on the second insulating layer 120, and a third insulating layer 130 may be disposed on the second gate electrode G2 and the second source electrode S2.

A first shielding layer SL1 and a first connection electrode CE1 are disposed on the third insulation layer 130.

The second active layer A2, the second gate electrode G2, and the second source electrode S2 constitute the driving thin film transistor T2 of the third sub-pixel SP3, and at least a portion of the second active layer A2, the second gate electrode G2, and the second source electrode S2 is disposed in an area of the second sub-pixel SP2.

That is, at least a portion of the driving thin film transistor T2 of the third sub-pixel SP3 is disposed in the area of the second sub-pixel SP2.

The first shielding layer SL1 may overlap at least a portion of the driving thin film transistor T2 of the third sub-pixel SP3 disposed in the area of the second sub-pixel SP2.

The first shielding layer SL1 is disposed between at least a portion of the driving thin film transistor T2 of the third sub-pixel SP3 and the first electrode 200b of the second sub-pixel SP2, thereby preventing parasitic capacitance between the driving thin film transistor T2 of the third sub-pixel SP3 and the first electrode 200b of the second sub-pixel SP2, and specifically the second sub-electrode 200b.

For example, the first shielding layer SL1 may overlap the second active layer A2, the second gate electrode G2, and the second source electrode S2 of the driving thin film transistor T2 of the third sub-pixel SP3 disposed in the area of the second sub-pixel SP2. Although not shown, the first shielding layer SL1 may overlap the second drain electrode D2 of the driving thin film transistor T2 of the third sub-pixel SP3 disposed in the area of the second sub-pixel SP2.

The first connection electrode CE1 may be connected to the second source electrode S2 through a contact hole disposed in the third insulating layer 130.

A fourth insulating layer 140 is disposed on the first shielding layer SL1 and the first connection electrode CE1, and the second sub-electrode 200b of the second sub-pixel SP2 and the first sub-electrode 200a of the third sub-pixel SP3 are disposed on the fourth insulating layer 140.

A bank 210 is disposed between the second sub-electrode 200b of the second sub-pixel SP2 and the first sub-electrode 200a of the third sub-pixel SP3.

A light emitting layer 220 is disposed on the sub-electrodes 200a and 200b and the bank 210, and a second electrode 230 is disposed on the light emitting layer 220.

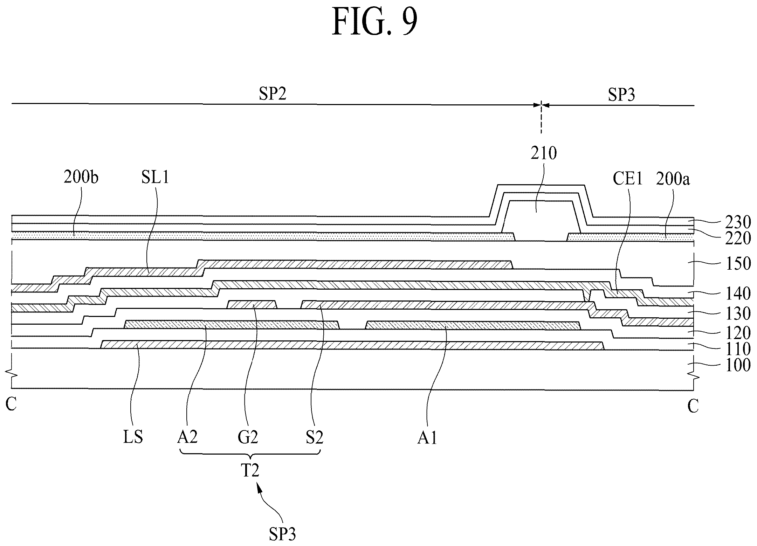

FIG. 9 is a cross-sectional view of an electroluminescent display device according to another embodiment of the present disclosure, which corresponds to a cross section taken along line C-C of FIG. 6. FIG. 9 is different from FIG. 8 described above in that the configurations of the first shielding layer SL1 and the first connection electrode CE1 are changed. Accordingly, the same reference numerals are assigned to the same configurations, and hereinafter, only different configurations will be described.

As shown in FIG. 9, a first connection electrode CE1 is disposed on a third insulation layer 130, a fourth insulating layer 140 is disposed on the first connection electrode CE1, a first shielding layer SL1 is disposed on the fourth insulating layer 140, a fifth insulating layer 150 is disposed on the first shielding layer SL1, and a first electrode 200a and 200b are disposed on the fifth insulating layer 150.

The first connection electrode CE1 extends from the third sub-pixel SP3 to the second sub-pixel SP2. The first connection electrode CE1 may overlap at least a portion of the driving thin film transistor T2 of the third sub-pixel SP3 disposed in an area of the second sub-pixel SP2.

For example, the first connection electrode CE1 may overlap the second active layer A2, the second gate electrode G2, and the second source electrode S2 of the driving thin film transistor T2 of the third sub-pixel SP3 disposed in the area of the second sub-pixel SP2. Although not shown, the first connection electrode CE1 may overlap the second drain electrode D2 of the driving thin film transistor T2 of the third sub-pixel SP3 disposed in the area of the second sub-pixel SP2.

Accordingly, since the first connection electrode CE1 is disposed between at least a portion of the driving thin film transistor T2 of the third sub-pixel SP3 and the first electrode 200b of the second sub-pixel SP2, a parasitic capacitance between the driving thin film transistor T2 of the third sub-pixel SP3 and the first electrode 200b of the second sub-pixel SP2 may be prevented. That is, the first connection electrode CE1 may function as a separate shielding layer.

In addition, the first shielding layer SL1 is disposed in the second sub-pixel SP2. The first shielding layer SL1 is disposed between a portion of the first connection electrode CE1 extending to the second sub-pixel SP2 and the first electrode 200b of the second sub-pixel SP2, thereby preventing a parasitic capacitance between the first connection electrode CE1 and the first electrode 200b of the second sub-pixel SP2.

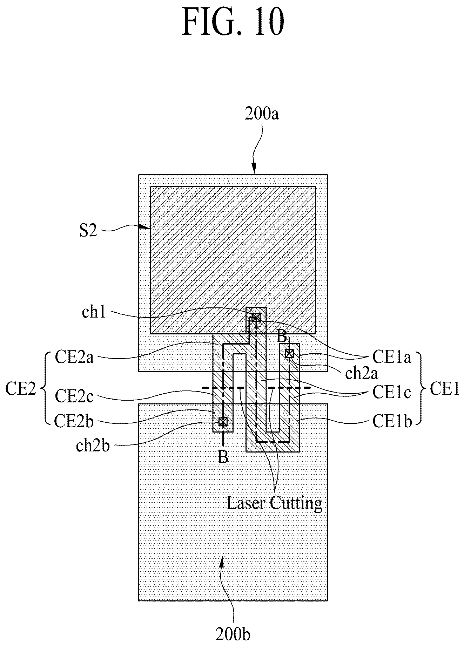

FIG. 10 is a plan view of an electroluminescent display device according to another embodiment of the present disclosure, which illustrates an electrical connection between a second source electrode S2 of a driving thin film transistor T2 and a first electrode 200a and 200b functioning as an anode of one sub-pixel.

As shown in FIG. 10, the first sub-electrode 200a and the second sub-electrode 200b are spaced apart from each other in the second direction, for example, in the vertical direction.

The second source electrode S2 is formed to overlap the first sub-electrode 200a and is formed not to overlap the second sub-electrode 200b. The second source electrode S2 may be formed not to overlap a spaced area between the first sub-electrode 200a and the second sub-electrode 200b.

The first sub-electrode 200a may be connected to the second source electrode S2 through a first connection electrode CE1, and the second sub-electrode 200b may be connected to the second source electrode S2 through a second connection electrode CE2.

One end of the first connection electrode CE1 may be connected to the second source electrode S2 through a first contact hole ch1, and the other end of the first connection electrode CE1 may be connected to the first sub-electrode 200a through a second contact hole ch2a. Accordingly, the first contact hole ch1 and the second contact hole ch2a may overlap the first sub-electrode 200a.

The first connection electrode CE1 may extend from an area overlapping the first sub-electrode 200a to an area overlapping the second sub-electrode 200b, and again from an area overlapping the second sub-electrode 200b to an area overlapping the first sub-electrode 200a. Accordingly, the third part CE1c of the first connection electrode CE1 may overlap a spaced area between the first sub-electrode 200a and the second sub-electrode 200b, and thus, when a short defect occurs, the third part CE1c of the first connection electrode CE1 may be easily disconnected by laser irradiation.

For example, the first part CE1a of the first connection electrode CE1 may overlap the first sub-electrode 200a, the second part CE1b of the first connection electrode CE1 may overlap the second sub-electrode 200b, and the third part CE1c of the first connection electrode CE1 may not overlap the first sub-electrode 200a and the second sub-electrode 200b.

In this case, the first part CE1a of the first connection electrode CE1 overlapping the first sub-electrode 200a may include two portions spaced apart from each other. Specifically, the two portions of the first part CE1a may include a portion connected to the first contact hole ch1 and a portion connected to the second contact hole ch2a. In addition, the second part CE1b of the first connection electrode CE1 overlapping the second sub-electrode 200b may be formed of a continuous portion in a U-shape. In addition, the third part CE1c of the first connection electrode CE1 not overlapping the first sub-electrode 200a and the second sub-electrode 200b may include two portions extending in parallel in a vertical direction. Specifically, the two portions of the third part CE1c may include a portion extending from the first contact hole ch1 and a portion extending from the second contact hole ch2a.

The first part CE1a of the first connection electrode CE1 may overlap the second source electrode S2, and the second part CE1b and the third part CE1c of the first connection electrode CE1 may not overlap the second source electrode S2. Accordingly, when the third part CE1c of the first connection electrode CE1 is cut by laser irradiation to repair a defect, the second source electrode S2 is not adversely affected by the laser irradiation.

The second connection electrode CE2 is branched from the first connection electrode CE1. The second connection electrode CE2 may be integrally formed with the first connection electrode CE1.

One end of the second connection electrode CE2 may be connected to the first part CE1a of the first connection electrode CE1, specifically, the first part CE1a connected to the first contact hole ch1, and the other end of the second connection electrode CE2 may be connected to the second sub-electrode 200b through a second contact hole ch2b. Accordingly, the second contact hole ch2b may overlap the second sub-electrode 200b.

The second connection electrode CE2 may extend from an area overlapping the first sub-electrode 200a to an area overlapping the second sub-electrode 200b. Accordingly, the third portion CE2c of the second connection electrode CE2 may overlap a spaced area between the first sub-electrode 200a and the second sub-electrode 200b, so that when a defect occurs, the third portion CE2c of the second connection electrode CE2 may be easily disconnected by laser irradiation.

For example, the first part CE2a of the second connection electrode CE2 may overlap the first sub-electrode 200a, the second part CE2b of the second connection electrode CE2 may overlap the second sub-electrode 200b, and the third part CE2c of the second connection electrode CE2 may not overlap the first sub-electrode 200a and the second sub-electrode 200b.

The first part CE2a of the second connection electrode CE2 may overlap the second source electrode S2, and the second part CE2b and the third part CE2c of the second connection electrode CE2 may not overlap the second source electrode S2. In some cases, the first part CE2a of the second connection electrode CE2 may also not overlap the second source electrode S2.

Accordingly, when the third part CE2c of the second connection electrode CE2 is cut by laser irradiation, the second source electrode S2 is not adversely affected by the laser irradiation.

The third part CE1c of the first connection electrode CE1 and the third part CE2c of the second connection electrode CE2 may be arranged in parallel with each other.

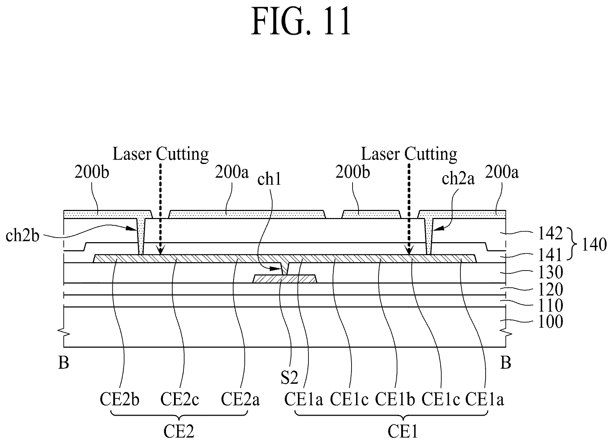

FIG. 11 is a cross-sectional view of an electroluminescent display device according to another embodiment of the present disclosure, which corresponds to a cross-section taken along line B-B of FIG. 10.

As can be seen from FIG. 11, a first insulating layer 110 is disposed on the substrate 100, and a second insulating layer 120 is disposed on the first insulating layer 110.

A second source electrode S2 is disposed on the second insulating layer 120, and a third insulating layer 130 is disposed on the second source electrode S2.

A first contact hole ch1 for electrical connection between the first connection electrode CE1 and the second source electrode S2 is disposed in the third insulating layer 130. The first contact hole ch1 for electrical connection between the first connection electrode CE1 and the second source electrode S2 may overlap the second source electrode S2.

A first connection electrode CE1 and a second connection electrode CE2 are disposed on the third insulating layer 130. The first connection electrode CE1 and the second connection electrode CE2 are integrally formed.

The first connection electrode CE1 is connected to the second source electrode S2 through the first contact hole ch1, and the second connection electrode CE2 is connected to the first connection electrode CE1 and extends in a direction different from the first connection electrode CE1.

Specifically, one first part CE1a of the first connection electrode CE1 is connected to the second source electrode S2 through the first contact hole ch1, and one third part CE1c, the second part CE1b, the other third part CE1c, and the other first part CE1a are continuously connected to the first part CE1a of the first connection electrode CE1.

The first part CE2a of the second connection electrode CE2 is connected to one first part CE1a of the first connection electrode CE1, and the third part CE2c and the second part CE2b are continuously connected to the first part CE2a of the second connection electrode CE2.

The first connection electrode CE1 and the second connection electrode CE2 include a portion that does not overlap the second source electrode S2. Specifically, the second portion CE1b and the third part CE1c of the first connection electrode CE1 and the second part CE2b and the third part CE2c of the second connection electrode CE2 may not overlap the second source electrode S2.

A fourth insulating layer 140 is disposed on the first connection electrode CE1 and the second connection electrode CE2.

The fourth insulating layer 140 may have a two-layer structure of a passivation layer 141 and a planarization layer 142 disposed on the passivation layer 141.

A second contact hole ch2a for electrical connection between the first connection electrode CE1 and the first sub-electrode 200a and a second contact hole ch2b for electrical connection between the second connection electrode CE2 and the second sub-electrode 200b are disposed in the fourth insulating layer 140.

The second contact hole ch2a for electrical connection between the first connection electrode CE1 and the first sub-electrode 200a and the second contact hole ch2b for electrical connection between the second connection electrode CE2 and the second sub-electrode 200b do not overlap the second source electrode S2.

A first electrode 200a and 200b are disposed on the fourth insulating layer 140.

The first electrode 200a and 200b may include a first sub-electrode 200a and a second sub-electrode 200b spaced apart from each other.

The first sub-electrode 200a is connected to the first connection electrode CE1 through the second contact hole ch2a, and the second sub-electrode 200b is connected to the second connection electrode CE2 through the second contact hole ch2b. Specifically, the first sub-electrode 200a is connected to the other first part CE1a of the first connection electrode CE1 through the second contact hole ch2a, and the second sub-electrode 200b is connected to the second part CE2b of the second connection electrode CE2 through the second contact hole ch2b.

The first sub-electrode 200a may overlap the first contact hole ch1 and the second contact hole ch2a, and the second sub-electrode 200b may overlap the second contact hole ch2b without overlapping the first contact hole ch1.

A spaced area between the first sub-electrode 200a and the second sub-electrode 200b does not overlap the second source electrode S2.

Although not shown, a light emitting layer 220 and a second electrode 230 are disposed on the first electrode 200a and 200b.

Each of the third part CE1c of the first connection electrode CE1 and the third part CE2c of the second connection electrode CE2 may overlap area separated between the first sub-electrode 200a and the second sub-electrode 200b. Accordingly, when a short defect occurs, the first connection electrode CE1 or the second connection electrode CE2 may be disconnected by irradiating a laser to the third part CE1c of the first connection electrode CE1 or the third part CE2c of the second connection electrode CE2.

For example, when a short defect occurs between wires in an area overlapping the first sub-electrode 200a, the first connection electrode CE1 may be disconnected by irradiating a laser to the third part CE1c of the first connection electrode CE1 through a spaced area between the first sub-electrode 200a and the second sub-electrode 200b.

In this way, when the first connection electrode CE1 is disconnected, the electrical connection between the first sub-electrode 200a and the second source electrode S2 is disconnected, so that light emission does not occur in an area overlapping the first sub-electrode 200a and light emission occurs only in an area overlapping the second sub-electrode 200b. In this case, since the laser is irradiated to a separated area between the first part S2a and the second part S2b of the second source electrode S2, the second source electrode S2 is not adversely affected due to the laser irradiation.

Similarly, when a short defect occurs between wires in an area overlapping the second sub-electrode 200b, the second connection electrode CE2 may be disconnected by irradiating a laser to the third part CE2c of the second connection electrode CE2 through a spaced area between the first sub-electrode 200a and the second sub-electrode 200b.

In this way, when the second connection electrode CE2 is disconnected, the electrical connection between the second sub-electrode 200b and the second source electrode S2 is disconnected, so that light emission does not occur in an area overlapping the second sub-electrode 200b and light emission occurs only in an area overlapping the first sub-electrode 200a. In this case, since the laser is irradiated to a separated area between the first portion S2a and the second portion S2b of the second source electrode S2, the second source electrode S2 is not adversely affected due to the laser irradiation.

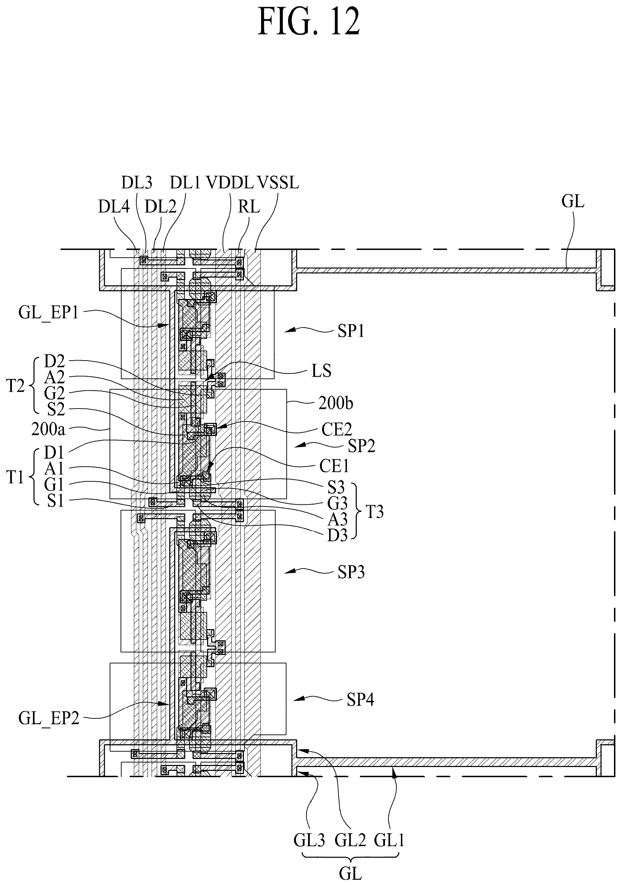

FIG. 12 is a plan view of an electroluminescent display device according to another embodiment of the present disclosure.

As shown in FIG. 12, a gate line GL are arranged in the first direction, for example, in the horizontal direction.

The gate line GL includes a first part GL1, a second part GL2, and a third part GL3. The first part GL1, the second part GL2, and the third part GL3 may be integrally formed.

The second part GL2 extends upward from one end of the first part GL1, extends in the horizontal direction, and then extends downward to be connected to the other end of the first part GL1. The third part GL3 extends downward from one end of the first part GL1, extends in the horizontal direction, and then extends upward to be connected to the other end of the first part GL1. The second part GL2 and the third part GL3 may have structures symmetrical to each other.

A gate line extension portion part GL-EP1 and GL-EP2 may extend from the gate line GL. The gate line extension portion part GL_EP1 and GL_EP2 may be integrally formed with the gate line GL.

A first gate line extension part GL_EP1 may extend in a downward direction in the gate line GL, for example, the third part GL3 of the gate line GL, and then may extend in a right direction again, and the second gate line extension part GL_EP2 may extend in an upward direction in the gate line GL, for example, the second part GL2 of the gate line GL, and then may extend in a right direction again.

The first gate line extension part GL_EP1 may extend downward to the second sub-pixel SP2 in the second direction, for example, in the vertical direction, from the gate line GL.

The second gate line extension part GL_EP2 may extend upward to the third sub-pixel SP3 in the second direction from the gate line GL.

For example, the third part GL3 of the gate line GL may supply a gate signal to the first sub-pixel SP1, the first gate line extension part GL_EP1 may supply a gate signal to the second sub-pixel SP2, the second gate line extension part GL_EP2 may supply a gate signal to the third sub-pixel SP3, and the second part GL2 of the gate line GL may supply a gate signal to the fourth sub-pixel SP4.

In this case, the first sub-pixel to the fourth sub-pixel SP1, SP2, SP3, and SP4 are arranged in the second direction, for example, in the vertical direction.

A high power line VDDL, a low power line VSSL, a data lines DL1, DL2, DL3, and DL4 and a reference line RL are arranged in the second direction crossing the first direction, for example, in the vertical direction.

The high power line VDDL, the low power line VSSL, the data lines DL1, DL2, DL3, and DL4, and the reference line RL may not overlap the first part GL1 of the gate line GL, but may overlap the second part GL2 and the third part GL3 of the gate line GL.

In the second direction, the fourth data line DL4, the third data line DL3, the second data line DL2, and the first data line DL1 may be arranged in order, but are not limited thereto.

The first data line DL1 supplies a data signal to the first sub-pixel SP1, the second data line DL2 supplies a data signal to the second sub-pixel SP2, the third data line DL3 supplies a data signal to the third sub-pixel SP3, and the fourth data line DL4 supplies a data signal to the fourth sub-pixel SP4.

The reference line RL may be disposed between the high power line VDDL and the low power line VSSL.

The high power line VDDL, the low power line VSSL, the data lines DL1, DL2, DL3, and DL4, and the reference line RL may be formed of the same material in the same layer. The high power line VDDL, the low power line VSSL, the data lines DL1, DL2, DL3, and DL4 and the reference line RL may be positioned below the gate line GL with an insulating layer therebetween.

In an area between the two gate lines GL, the first sub-pixel SP1, the second sub-pixel SP2, the third sub-pixel SP3, and the fourth sub-pixel SP4 may be sequentially disposed in the vertical direction.

Each of the sub-pixels SP1, SP2, SP3, and SP4 may include a light emitting area, a line area, and a circuit area. In this case, the light emitting area may overlap the circuit area, and in this case, the electroluminescent display device may be configured in a top emission type.

In addition, a right area of the sub-pixels SP1, SP2, SP3, and SP4 may be formed of a transmissive area through which external light may transmit. For example, the transmissive area may be defined by the low power line VSSL of one pixel, the fourth data line DL4 of the other pixel, and two gate lines GL.

The data lines DL1, DL2, DL3 and DL4 may be disposed adjacent to each other without other wirings being disposed therebetween. In addition, other signal lines may not be disposed between the reference line RL and the high power line VDDL and between the reference line RL and the low power line VSSL.

Thus, according to another embodiment of the present disclosure, various lines are adjacent to each other to form the line area, and the circuit area including a plurality of thin film transistors T1, T2, and T3 is arranged to be adjacent to the line area, thereby reducing a total size of the line area and the circuit area. Accordingly, a resolution can be increased by reducing a size of the light emitting area, and a size of the transmissive area can also be increased.

A switching thin film transistor T1, a driving thin film transistor T2, and a sensing thin film transistor T3 are disposed in the circuit area of each of the four sub-pixels SP1, SP2, SP3, and SP4.

The switching thin film transistor T1 includes a first gate electrode G1, a first source electrode S1, a first drain electrode D1, and a first active layer A1.

The first gate electrode G1 of the first sub-pixel SP1 may include the third part GL3 of the gate line GL, the first gate electrode G1 of the second sub-pixel SP2 may include the first gate line extension part GL_EP1, the first gate electrode G1 of the third sub-pixel SP3 may include the third gate line extension part GL_EP3, and the first gate electrode G1 of the fourth sub-pixel SP4 may include the second part GL2 of the gate line GL.

The first source electrode S1 may be connected to the data lines DL1, DL2, DL3, and DL4 through a contact hole, and may be connected to one end of the first active layer A1 through a contact hole.

The first drain electrode D1 may be disposed on the same layer as the first source electrode S1, and may be connected to the other end of the first active layer A1 through a contact hole.

The first source electrode S1 and the first drain electrode D1 may be formed of the same material as the first gate electrode G1, but are not limited thereto.

The first active layer A1 may be connected to the first source electrode S1 and the first drain electrode D1 through a contact hole, respectively, to function as an electron moving channel.

The driving thin film transistor T2 includes a second gate electrode G2, a second source electrode S2, a second drain electrode D2, and a second active layer A2.

The second gate electrode G2 may be connected to the first drain electrode D1 of the switching thin film transistor T1. The second gate electrode G2 may be integrally formed with the first drain electrode D1, but is not limited thereto.

The second source electrode S2 may be connected to one end of the second active layer A2 through a contact hole. The second source electrode S2 may be connected to a light blocking layer LS thereunder through a contact hole.

The light blocking layer LS may be formed of the same material in the same layer as the high power line VDDL, the low power line VSSL, the data lines DL1, DL2, DL3, and DL4, and the reference line RL. The light blocking layer LS may overlap the second active layer A2 to block external light from being incident on the second active layer A2. In addition, the light blocking layer LS may function as a capacitor electrode. Specifically, the light blocking layer LS and the second gate electrode G2 may overlap each other with an insulating layer therebetween, so that a capacitor may be formed by the light blocking layer LS and the second gate electrode G2.

The second source electrode S2 may be connected to two connection electrodes CE1 and CE2 through contact holes. The two connection electrodes CE1 and CE2 may be disposed above the gate line GL with an insulating layer interposed therebetween.

The first connection electrode CE1 and the second connection electrode CE2 may be connected to the second source electrode S2 through contact holes, respectively.

The first connection electrode CE1 may be connected to a first sub-electrode 200a that functions as one anode through a contact hole, and the second connection electrode CE2 may be connected to a second sub-electrode 200b that functions as the other anode through a contact hole. Accordingly, the first electrodes 200a and 200b of one sub-pixel may be formed of two sub-electrodes 200a and 200b that are spaced apart from each other. The two sub-electrodes 200a and 200b may be driven at the same time, or only one sub-electrode 200a and 200b may be driven by a repair process for solving defects.

The second drain electrode D2 may be connected to the other end of the second active layer A2 through a contact hole.

The second drain electrode D2 may be connected to the high power line VDDL through a contact hole.

The second source electrode S2 and the second drain electrode D2 may be formed of the same material as the second gate electrode G2, but are not limited thereto.

In some cases, a configuration connected to the high power line VDDL may function as a source electrode, and a configuration connected to the first electrodes 200a and 200b through the connection electrodes CE1 and CE2 may function as a drain electrode.

The second active layer A2 may be connected to the second source electrode S2 and the second drain electrode D2 through a contact hole, respectively, to function as an electron moving channel. The second active layer A2 may be formed of the same material on the same layer as the first active layer A1.

The sensing thin film transistor T3 includes a third gate electrode G3, a third source electrode S3, a third drain electrode D3, and a third active layer A3.

The third gate electrode G3 of the first sub-pixel SP1 may include the third part GL3 of the gate line GL, the third gate electrode G3 of the second sub-pixel SP2 may include the first gate line extension part GL_EP1, the third gate electrode G3 of the third sub-pixel SP3 may include the third gate line extension part GL_EP3, and the third gate electrode G3 of the fourth sub-pixel SP4 may include the second part GL2 of the gate line GL.

The third source electrode S3 may be integrally formed with the second source electrode S2 of the driving thin film transistor T2. Alternatively, the third source electrode S3 may be connected to the light blocking layer LS through a contact hole, and thus may be electrically connected to the second source electrode S2 of the driving thin film transistor T2 through the light blocking layer LS.

The third source electrode S3 may be connected to one end of the third active layer A3 through a contact hole.

The third drain electrode D3 is formed on the same layer as the third source electrode S3, and may be connected to the other end of the third active layer A3 through a contact hole. In addition, the third drain electrode D3 may be connected to the reference line RL through a contact hole.

The third active layer A3 may be connected to the third source electrode S3 and the third drain electrode D3 through a contact hole, respectively, to function as an electron moving channel. The third active layer A3 may be formed of the same material on the same layer as the first active layer A1.

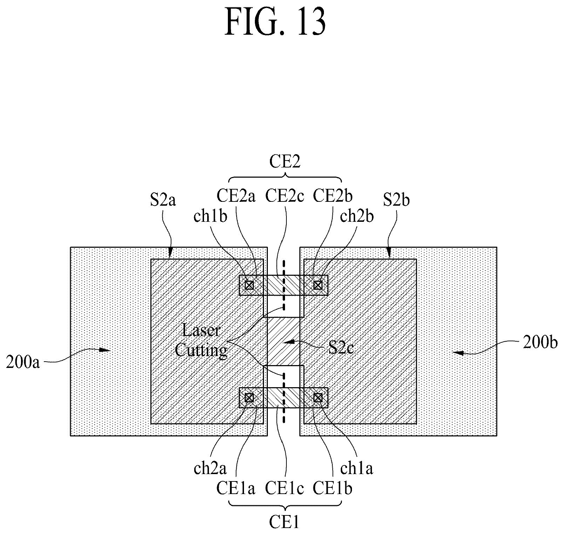

FIG. 13 is a plan view of an electroluminescent display device according to another embodiment of the present disclosure, which illustrates an electrical connection between a second source electrode S2 of a driving thin film transistor T2 and a first electrode 200a and 200b functioning as an anode of one sub-pixel.

FIG. 13 differs from FIG. 4 described above in that the first sub-electrode 200a and the second sub-electrode 200b are spaced apart from each other in the first direction, for example, in the horizontal direction.

The second source electrode S2 includes a first part S2a overlapping the first sub-electrode 200a, a second part S2b overlapping the second sub-electrode 200b, and a third part S2c overlapping a spaced area between the first sub-electrode 200a and the second sub-electrode 200b while connecting the first part S2a and the second part S2b.

A width of the third part S2c in the second direction, for example, in the vertical direction, may be less than a width of the first part S2a in the second direction and a width of the second part S2b in the second direction. Accordingly, the first part S2a and the second part S2b may overlap the first connection electrode CE1 and the second connection electrode CE2, but the third part S2c may not overlap the first connection electrode CE1 and the second connection electrode CE2.

The first sub-electrode 200a may be connected to the second source electrode S2 by the first connection electrode CE1, and the second sub-electrode 200b may be connected to the second source electrode S2 by the second connection electrode CE2.

One end of the first connection electrode CE1 may be connected to the second source electrode S2 through a first contact hole ch1a, and the other end of the first connection electrode CE1 may be connected to the first sub-electrode 200a through a second contact hole ch2a. The first connection electrode CE1 may extend from an area overlapping the second sub-electrode 200b to an area overlapping the first sub-electrode 200a while formed in the first direction. Accordingly, the first contact hole ch1a may overlap the second sub-electrode 200b, and the second contact hole ch2a may overlap the first sub-electrode 200a.

For example, the first part CE1a of the first connection electrode CE1 may overlap the first sub-electrode 200a, the second part CE1b of the first connection electrode CE1 may overlap the second sub-electrode 200b, and the third part CE1c of the first connection electrode CE1 may not overlap the first sub-electrode 200a and the second sub-electrode 200b while connecting the first part CE1a and the second part CE1b.

In addition, the first part CE1a of the first connection electrode CE1 may overlap the first part S2a of the second source electrode S2, and the second part CE1b of the first connection electrode CE1 may overlap the second part S2b of the second source electrode S2, but the third part CE1c of the first connection electrode CE1 may not overlap an entire part of the second source electrode S2 including the third part S2c of the second source electrode S2. Accordingly, when the third part CE1c of the first connection electrode CE1 is cut by laser irradiation, the second source electrode S2 is not adversely affected by the laser irradiation.

One end of the second connection electrode CE2 may be connected to the second source electrode S2 through the first contact hole ch1b, and the other end of the second connection electrode CE2 may be connected to the second sub-electrode 200b through the second contact hole ch2b. The second connection electrode CE2 may extend from an area overlapping the first sub-electrode 200a to an area overlapping the second sub-electrode 200b while formed in the first direction. Accordingly, the first contact hole ch1b may overlap the first sub-electrode 200a, and the second contact hole ch2b may overlap the second sub-electrode 200b.

For example, the first part CE2a of the second connection electrode CE2 may overlap the first sub-electrode 200a, the second part CE2b of the second connection electrode CE2 may overlap the second sub-electrode 200b, and the third part CE2c of the second connection electrode CE2 may not overlap the first sub-electrode 200a and the second sub-electrode 200b while connecting the first part CE2a and the second part CE2b.

In addition, the first part CE2a of the second connection electrode CE2 may overlap the first part S2a of the second source electrode S2, and the second part CE2b of the second connection electrode CE2 may overlap the second part S2b of the second source electrode S2, but the third part CE2c of the second connection electrode CE2 may not overlap an entire part of the second source electrode S2 including the third part S2c of the second source electrode S2. Accordingly, when the third part CE2c of the second connection electrode CE2 is cut by laser irradiation, the second source electrode S2 is not adversely affected by the laser irradiation.

The third part CE1c of the first connection electrode CE1 and the third part CE2c of the second connection electrode CE2 may be arranged in parallel with each other.

It will be apparent to those skilled in the art that the present disclosure described above is not limited by the above-described embodiments and the accompanying drawings and that various substitutions, modifications and variations can be made in the present disclosure.

The various embodiments described above can be combined to provide further embodiments. These and other changes can be made to the embodiments in light of the above-detailed description.

## Claims

1. A display device comprising:
a substrate (100) including a plurality of sub-pixels (SP1, SP2, SP3, SP4);
a driving thin film transistor (T2) disposed in each of the plurality of sub-pixels (SP1, SP2, SP3, SP4) on the substrate (100) and including a source electrode (S2) and a drain electrode (D2); and
a first electrode disposed in each of the plurality of sub-pixels (SP1, SP2, SP3, SP4) on the substrate (100) and connected to the source electrode (S2) or the drain electrode (D2),
wherein the first electrode comprises a first sub-electrode (200a) and a second sub-electrode (200b) spaced apart from each other in a first direction, and
wherein the first sub-electrode (200a) is electrically connected to the source electrode (S2) or the drain electrode (D2) through a first connection electrode (CE1), and the second sub-electrode (200b) is electrically connected to the source electrode (S2) or the drain electrode (D2) through a second connection electrode (CE2).

2. The display device of claim 1, wherein the source electrode (S2) or the drain electrode (D2) overlaps the first sub-electrode (200a) and the second sub-electrode (200b).

3. The display device of claim 1 or 2,
wherein the source electrode (S2) or the drain electrode (D2) includes:
a first part (S2a) overlapping the first sub-electrode (200a);
a second part (S2b) overlapping the second sub-electrode (200b); and
a third part (S2c) overlapping a region between the first sub-electrode (200a) and the second sub-electrode (200b) defined by a spacing therebetween while connecting the first part (S2a) with the second part (S2b).

4. The display device of claim 3, wherein a width of the third part (S2c) in the first direction is smaller than a width of the first part (S2a) in the first direction and a width of the second part (S2b) in the first direction and/or
wherein the first connection electrode (CE1) and the second connection electrode (CE2) overlap the first part (S2a) and the second part (S2b), and do not overlap the third part (S2c).

5. The display device of any of the preceding claims, wherein each of the first connection electrode (CE1) and the second connection electrode (CE2) extends from an area overlapping the first sub-electrode (200a) to an area overlapping the second sub-electrode (200b).

6. The display device of any of the preceding claims, wherein a first end of the first connection electrode (CE1) is connected to the source electrode (S2) or the drain electrode (D2) through a first contact hole (ch1), a second end of the first connection electrode (CE1) is connected to the first sub-electrode (200a) through a second contact hole (ch2), and
wherein the first contact hole (ch1) is positioned to overlap, in plan view, the second sub-electrode (200b), and the second contact hole (ch2) is positioned to overlap, in plan view, the first sub-electrode (200a); or
wherein a first end of the second connection electrode (CE2) is connected to the source electrode (S2) or the drain electrode (D2) through a first contact hole (ch1), a second end of the second connection electrode (CE2) is connected to the second sub-electrode (200b) through a second contact hole (ch2), and
wherein the first contact hole (ch1) is positioned to overlap, in plan view, the first sub-electrode (200a), and the second contact hole (ch2) is positioned to overlap, in plan view, the second sub-electrode (200b).

7. The display device of any of the preceding claims 3 to 6,
wherein the first connection electrode (CE1) includes:
a first part (CE1a) overlapping the first sub-electrode (200a);
a second part (CE1b) overlapping the second sub-electrode (200b); and
a third part (CE1c) connecting the first part with the second part (CE1b) while not overlapping the first sub-electrode (200a) and the second sub-electrode (200b).

8. The display device of claim 7, wherein the first part (CE1a) of the first connection electrode (CE1) overlaps the first part (S2a) of the source electrode (S2) or the drain electrode (D2),
wherein the second part (CE1b) of the first connection electrode (CE1) overlaps the second part (S2b) of the source electrode (S2) or the drain electrode (D2), and
wherein the third part (CE1c) of the first connection electrode (CE1) does not overlap the third part (S2c) of the source electrode (S2) or the drain electrode (D2),
wherein preferably the third part (CE1c) of the first connection electrode (CE1) is disconnected.

9. The display device of any of the preceding claims, wherein the source electrode (S2) or the drain electrode (D2) overlaps the first sub-electrode (200a), and does not overlap the second sub-electrode (200b).

10. The display device of claim 9, wherein a first end of the first connection electrode (CE1) is connected to the source electrode (S2) or the drain electrode (D2) through a first contact hole (ch1), and a second end of the first connection electrode (CE1) is connected to the first sub-electrode (200a) through a second contact hole (ch2).

11. The display device of claim 12, wherein the first connection electrode (CE1) extends from the first sub-electrode (200a) to the second sub-electrode (200b) via a first route, and from the second sub-electrode (200b) to the first sub-electrode (200a) via a second route different from the first route.

12. The display device of claim 11,
wherein the first connection electrode (CE1) includes:
two first parts (CE1a) overlapping the first sub-electrode (200a) and spaced apart from each other;
a second part (CE1b) overlapping the second sub-electrode (200b); and
two third parts (CE1c) disposed between the first part and the second part (CE1b) and disposed in a spaced area between the first sub-electrode (200a) and the second sub-electrode (200b).

13. The display device of any of claims 9 to 12, wherein the second connection electrode (CE2) branches from the first connection electrode (CE1), and/or
wherein a first end of the second connection electrode (CE2) overlaps the first sub-electrode (200a), and a second end of the second connection electrode (CE2) overlaps the second sub-electrode (200b).

14. A display device comprising:
a substrate (100);
a first insulating layer (110) on the substrate (100);
a source electrode (S2) or a drain electrode (D2) of a driving thin film transistor (T2) on the first insulating layer;
a second insulating layer (120) on the source electrode (S2) or the drain electrode (D2);
a connection electrode disposed on the second insulating layer and electrically connected to the source electrode (S2) or the drain electrode (D2) through one of a plurality of first contact holes disposed in the second insulating layer;
a third insulating layer (130) on the connection electrode; and
a first electrode disposed on the third insulating layer and connected to the connection electrode through one of a plurality of second contact holes disposed in the third insulating layer,
wherein the connection electrode includes a first connection electrode (CE1) connected to the source electrode (S2) or the drain electrode (D2) through the first contact hole, and a second connection electrode (CE2) formed as one body with the first connection electrode (CE1) and extended in a direction different from the first connection electrode (CE1), and
wherein the first electrode includes a first sub-electrode (200a) connected to the first connection electrode (CE1) through one of the second contact hole, and a second sub-electrode (200b) spaced apart from the first sub-electrode (200a) and connected to the second connection electrode (CE2) through another of the second contact hole.

15. The display device of claim 14, wherein a region between the first sub-electrode (200a) and the second sub-electrode (200b), defined by the spacing therebetween, overlaps a part of the first connection electrode (CE1) and a part of the second connection electrode (CE2) in plan view, and does not overlap the source electrode (S2) or the drain electrode (D2).
